Europäisches Patentamt

European Patent Office

Office européen des brevets

(19)

(11)  **EP 0 867 919 B1**

(12)  **EUROPEAN PATENT SPECIFICATION**

(45) Date of publication and mention
of the grant of the patent:
**08.09.2004   Bulletin 2004/37**

(51) Int Cl.⁷: **H01L 21/20**, H01L 21/762,
H01L 27/12

(21) Application number: **98302187.4**

(22) Date of filing: **24.03.1998**

(54) **Semiconductor substrate and process for producing same**

Halbleitersubstrat und Verfahren zu dessen Herstellung

Substrat semiconducteur et procédé de sa fabrication

(84) Designated Contracting States:
**AT BE CH DE ES FR GB IT LI NL PT SE**

(30) Priority:  **26.03.1997   JP 7351997**

(43) Date of publication of application:
**30.09.1998   Bulletin 1998/40**

(73) Proprietor: **CANON KABUSHIKI KAISHA**
**Tokyo (JP)**

(72) Inventors:
 • **Ohmi, Kazuaki**
   **Ohta-ku, Tokyo (JP)**
 • **Yonehara, Takao**
   **Ohta-ku, Tokyo (JP)**
 • **Sakaguchi, Kiyofumi**
   **Ohta-ku, Tokyo (JP)**

(74) Representative:
   **Beresford, Keith Denis Lewis et al**
   **BERESFORD & Co.**
   **16 High Holborn**
   **London WC1V 6BX (GB)**

(56) References cited:
   **EP-A- 0 755 068          EP-A- 0 797 258**
   **EP-A- 0 840 381          EP-A- 0 843 346**
   **US-A- 5 439 843**

**Description**

BACKGROUND OF THE INVENTION

Field of the Invention

The present invention relates to a process for producing a semiconductor substrate, and more particularly a process for producing a semiconductor substrate provided with a plurality of porous layers.

Related Background Art

The formation of a single crystal Si semiconductor layer on an insulator is widely known as semiconductor-on-insulator (SOI) technology, and various researches have been made because the device utilizing the SOI technology has various advantages that cannot be attained in the bulk Si substrate utilized for the preparation of ordinary Si integrated circuits. More specifically, the use of the SOI technology provides various advantages such as:

1. easy dielectric separation and a higher degree of integration;
2. superior radiation resistance;
3. a reduced stray capacitance leading to a higher speed;
4. a well forming step being dispensed with;
5. prevention of latch-up; and
6. possibility of a fully depleted field effect transistor by a thin film structure.

In order to realize the various advantages in the device characteristics mentioned above, methods for forming the SOI structure have been investigated for many years. The contents of these investigations are summarized for example in Special Issue: "Single-crystal silicon on non-single-crystal insulators": edited by G. W. Cullen, Journal of Crystal Growth, Vol. 63, No. 3, pp.429-590 (1983). In the initial period, there have been known the SOS (silicon on sapphire) formed by heteroepitaxially growing silicon using CVD (chemical vapor deposition) on a single-crystal sapphire substrate . Though this technology attained certain success as the most mature SOI technology, its wider application has been prevented by a large amount of crystal defects resulting from lattice mismatching at an interface between the Si layer and the underlying sapphire substrate, contamination with aluminum from the sapphire substrate, and, in particular, the expensiveness of the substrate and the delay in providing large-area substrates. More recently there have been made attempts to realize the SOI structure without using a sapphire substrate. These attempts can be divided into the following two categories:

(1) After an Si single-crystal substrate is surface-oxidized, a window is formed to partially expose the Si substrate, and lateral epitaxial growth is conducted utilizing the exposed portion as a seed, thereby forming an Si single-crystal layer on the SiO$_2$ (involving an Si layer deposition on the SiO$_2$); and
(2) An Si single-crystal substrate itself is utilized as an active layer and SiO$_2$ is formed thereunder (not involving Si layer deposition).

The devices formed on a compound semiconductor have excellent features, such as a high speed, light emission or the like, which are not achievable with those on a silicon substrate. Presently the devices are mostly formed in a layer epitaxially grown on a compound semiconductor substrate such as GaAs or the like.

However the compound semiconductor substrates are associated with drawbacks such as expensiveness, a low mechanical strength and difficulty of preparation of a large-area wafer.

Under such situation, there has been made an attempt to heteroepitaxially grow a compound semiconductor on the silicon wafer which is inexpensive, mechanically strong and can be easily prepared with a large area.

In the above-mentioned category (1), there are known a method of direct lateral epitaxial growth of a single-crystal layer Si by CVD, a method of depositing amorphous Si and causing solid-phase lateral epitaxial growth by heat treatment, a method of irradiating an amorphous or polycrystal Si layer with a focused energy beam such as an electron beam or a laser beam to grow a single-crystal layer on SiO$_2$ by melting and recrystallization, and a zone melting recrystallization method of scanning with a zone like melted region formed by a rod-like heater. These methods have respective advantages and disadvantages, but none has been industrially commercialized in view of still great room for improvement in the controllability, productivity, uniformity and product quality. More specifically, the CVD method necessitates sacrifice oxidation for obtaining a flattened thin film, while the solid-phase growth method is insufficient in the crystallinity. Also the beam annealing method has problems in the processing time required by the focused beam scanning and in the controllability of beam overlapping degree and beam focusing. The zone melting recrystallization method is most advanced to a level that relatively large-scale integrated circuits have been experimentally manufactured, but the substrate still contains large number of crystal defects such as sub grain boundaries and has not reached a level enough for the preparation of minority carrier devices.

On the other hand, in the category (2) not utilizing an Si substrate as the seed of epitaxial growth, there are included the following four methods:

(a) An oxide film is formed on an Si single-crystal substrate on a surface of which V-shaped grooves are formed by anisotropical etching, then a polycrystal Si layer is deposited, on the oxide film, with a thickness comparable to that of the Si substrate, and the Si substrate is polished from the rear surface to form, on the thick polycrystal Si layer, Si single-crystal regions surrounded and dielectrically isolated by the V-shaped grooves. This method can provide satisfactory crystallinity, but has a problem in the controllability and the productivity of a step of depositing polycrystal Si as thick as several hundred microns and a step of polishing the single-crystal Si substrate from the rear surface so as to leave the isolated Si active layer only;

(b) So-called SIMOX (separation by ion implanted oxygen) method utilizes formation of an $SiO_2$ layer by oxygen ion implantation into an Si single-crystal substrate and is currently most advanced because of the good matching with the Si process. However the formation of an $SiO_2$ layer requires oxygen ion implantation of $10^{18}$ ions/cm$^2$ or larger, thus necessitating a very long implantation time, leading to a limited productivity and a high wafer cost. Also there still remains a large number of crystal defects, and this method has not industrially reached a product quality enough for producing the minority carrier devices;

(c) There is also known a method of forming the SOI structure by dielectric isolation by oxidation of porous Si. This method consists of forming an N-type Si layer in an island shape on a surface of a P-type Si single-crystal substrate either by proton ion implantation (Imai et al., J. Crystal Growth, Vol. 63, 547 (1983)) or by epitaxial growth and patterning, then effecting anodization in an HF solution from the surface so as to surround the Si island to thereby make only the P-type Si substrate porous, and effecting dielectric isolation of the N-type Si island by accelerated oxidation. In this method the isolated Si area is defined prior to the device process so that the freedom of device designing may be limited; and

(d) In addition to the conventional SOI forming methods described above, there is recently contemplated a method of bonding an Si single-crystal substrate by heat treatment or with an adhesive to another thermally oxidized Si single-crystal substrate to form the SOI structure. In this method, the active layer for device formation has to be formed as a uniform thin film. Stated differently an Si single-crystal substrate of a thickness of several hundred micrometers has to be made into a thin film in the order of a micrometer or less. The following two methods are being proposed for this purpose:

(a) thin film formation by polishing;
(b) thin film formation by selective etching.

However the method (a) is difficult to provide a uniform thin film. In particular, in case of a thin film of submicron thickness, there is a problem that the fluctuation in thickness becomes as high as several tens of percent and the difficulty becomes severer with the increase in the wafer diameter.

The method (b) is considered effective for obtaining a uniform thin film, but is associated with the following limitations:

- selectivity, being about $10^2$, is not sufficient;
- insufficient surface property after etching; and
- crystallinity of the semiconductor layer on the insulating film (SOI layer) is insufficient because epitaxial or heteroepitaxial growth is utilized on the highly B-doped Si layer formed by ion implantation (C. Harendt et al., J. Elect. Mater., Vol. 20, 267 (1991), H. Baumgart et al., Extended Abstract of ECS 1st International Symposium of Wafer Bonding, pp. 733 (1991), C. E. Hunt, Extended Abstract of ECS 1st International Symposium of Wafer Bonding, pp. 696 (1991)).

Further, the semiconductor substrate employing the bonding always necessitates two wafers, one of which is mostly eliminated by polishing or etching, thus resulting in significant waste of the limited resources of the earth.

Consequently the SOI employing the bonding currently has various problems in the controllability, uniformity and economical property.

Also in case of a light-transmissive substrate represented by glass, a thin film Si layer deposited thereon usually becomes amorphous or polycrystal at best, reflecting the disorder of the substrate, so that a high-performance device cannot be prepared. This is based on a fact that the substrate is amorphous, and a mere deposition of an Si layer thereon will not provide a fine quality single-crystal layer.

However, such a light-transmissive substrate is important in constructing a contact sensor which is a light receiving element, or a projection-type liquid crystal image display device, and, for forming the pixels (image elements) of such a sensor or display device with a higher density, a higher resolution and a higher precision, there are required driving elements of higher performance. Consequently, the devices provided on the light-transmissive substrate have to be prepared with a single-crystal layer of excellent crystallinity.

Thus, it is difficult to produce the driving elements of sufficient performance matching the current or future requirement in amorphous or polycrystal Si because of the crystal structure with a large amount of crystal defects.

As explained in the foregoing, a compound semiconductor substrate is essential for producing a compound semiconductor device. However the compound semiconductor substrate is expensive, and the preparation of the large-area substrate is extremely difficult.

Also it has been tried to epitaxially grow a compound semiconductor such as GaAs or the like on an Si substrate, but thus grown film shows insufficient crystallinity because of the differences in the lattice constant and in the thermal expansion coefficient, so that it is extremely difficult to apply such a film for device production.

It has further been tried to epitaxially grow a compound semiconductor on porous Si in order to relax the lattice mismatching, but the obtained substrate lacks the stability and the reliability during or after the preparation of the device, because of the low thermal stability and the time-dependent change of the porous Si.

Of the above-described producing methods for the SOI wafer, the method of forming a non-porous single-crystal semiconductor layer on a porous layer and transferring the semiconductor layer onto a support substrate via an insulation layer, as disclosed in the Japanese Patent Application Laid-Open No. 5-21338, is superior in consideration of the excellent thickness uniformity of the SOI layer, easy control of the crystal defect density of the SOI layer at a low level, excellent surface flatness of the SOI layer, absence of necessity for an expensive manufacturing apparatus of special specifications, and possibility of production, in the same apparatus, of SOI films of a wide thickness range from several tens nm (hundred Angstroms) to about 10 $\mu$m (micrometer).

As described in an example of Japanese Patent Application Laid-Open No. 7-302889, by bonding a first substrate and a second substrate to each other, then separating the first and the second substrates without destruction thereof at a sole (single) porous layer, smoothing a residue layer of the porous layer remaining on the surfaces of the first and second substrates, respectively and again forming a porous layer thereon for reuse, it is possible to use the first substrate several times. Thus, there can be obtained significant advantages of significantly reducing the production cost and simplifying the production process itself. A similar process is described in the document EP-A-0 755 068.

However, the separation of the bonded wafers at the porous layer is generally possible using the above-mentioned method, there still remain certain problems to be solved. For example, the separation of the bonded wafers at the porous layer may result in a partial destruction of the first or second substrate, or in introduction of defects such as cracks or dislocations into the non-porous single-crystal semiconductor layer formed on the porous layer. Also, there is a case where the separation at the porous layer can not be attained though the reason is unclarified and the frequency of such phenomenon is low. For achieving stable separation, it is effective, as disclosed in another example of the above mentioned Japanese Patent Application Laid-Open No. 7-302889, to vary the current in the course of anodization, thereby forming two porous layers.

In such a method, the separation of the bonded substrates becomes easier, but the porous layer may be broken in advance in any one of the steps from the anodization step for forming the porous layer to the completion of the bonding step. Such premature destruction may render the bonding step impossible or may cause contamination of the production steps by the particles generated from the broken porous layer or from the non-porous single-crystal layer formed thereon. For example, if the porous layer is peeled off even in a part in the course of the anodization in the anodizing apparatus, it becomes no longer possible to uniformly form a non-porous single-crystal layer on a substrate of such a substrate.

Also in case of peeling off of the porous layer in the electrolyte in an anodizing tank, uniform peeling off and recovery of the porous layer only can be rarely expected, but a part of the porous layer may usually be peeled off partly. Otherwise, the peeled off porous layer may be broken finely to cause scattering of fine particles of the porous layer. Such particles may be deposited on a surface of another first substrate to lower the surface uniformity of the porous layer and to form pinholes in the non-porous semiconductor layer at the formation thereof. Further, such particles may further lower the thickness uniformity of the semiconductor layer or generate crystal defects therein. In addition, such deposited particles may induce formation of voids which become non-bonded portions when bonding the two substrates to each other.

Such peeling off of the porous layer prior to the bonding step may be caused not only in the anodizing step but also in any step before or after the bonding step, such as a subsequent oxidation step in a heating oven, a subsequent non-porous semiconductor layer forming step in a CVD apparatus or the like, an annealing step in a heating oven after the bonding step for improving the bonding strength, or a cleaning step required repeatedly between the respective steps.

The destruction of even a part of the porous layer in any of these steps renders the preparation of the desired semiconductor substrate impossible, and, if the various processing apparatuses are contaminated with the particles of the broken pieces of the porous layer, such apparatuses have to be ceased to be used and the particles must be thoroughly removed.

Even if the destruction of the porous layer does not occur prior to the separating step, there is a case where the porous layer remaining on the non-porous semiconductor layer transferred onto the second substrate may not be uniform in thickness within the substrate surface. Such uneven thickness results from partial destruction or peeling off of the porous layer. In the presence of the porous layer with such uneven thickness, the non-porous semiconductor layer may be excessively etched locally in the subsequent etching process, whereby a layer of uniform thickness may not be obtained.

A method to use a two-layer porous region, the porous layers having different porosities, is described in the document EP-A-0 797 258, which constitutes prior art only in the sense of Article 54 (3) and (4) EPC.

SUMMARY OF THE INVENTION

An object of the present invention is to provide a semiconductor substrate in which the destruction of the porous region is difficult to occur prior to the separation of the bonded substrates, and a process for producing the same.

Another object of the present invention is to provide a semiconductor substrate in which the separation takes place reproducible at a predetermined position of the porous region, and a process for producing the same.

Still another object of the present invention is to provide a semiconductor substrate capable of inexpensively providing an SOI substrate of satisfactory quality, and a process for producing the same.

The above-mentioned objects can be attained, according to the present invention, by a process for producing a semiconductor substrate as set out in appended claim 1.

According to the present invention, there is also provided a composite member for a semiconductor substrate, as set out in claim 21 for the Contracting States DE, FR, and GB, and in claim 22 for the Contracting States AT, BE, CH, LI, ES, IT, NL, PT, and SE.

The term "porosity" as used in the specification and claims refers to the proportion of the volume as occupied by the pores with respect to the material constituting the porous layer, within the volume of the porous layer.

In order to facilitate the separation after the bonding, the porosity of the second porous layer is maintained within a range from 30% to 60%, preferably from 40% to 60%. The separation is still possible at a porosity lower than such a range. However, there is a case where during the separation, there may result a partial destruction, a crack or a slip dislocation in the first or the second substrate or in the non-porous layer formed on the porous layer of the first substrate. In order to prevent such phenomena the porosity is maintained in the range of 30% to 60%. Further, when the thickness of the first porous layer adjacent to the non-porous semiconductor layer is defined as "t1" and the thickness of the second porous layer is defined as "t2", there is satisfied a relationship $0.8\ t1 \geq t2$. Thus t2 is selected so as to be not more than 80%, preferably 50%, of t1. By satisfying such a relationship, the porous region remaining on the non-porous semiconductor layer after the separation becomes substantially uniform in thickness within the surface of the second substrate. Thus, by selectively etching the remaining porous region thereafter, the thickness of the non-porous semiconductor layer that remains without being etched becomes uniform.

The presence of the porous region having the above-described relative relationships as to the porosities and the thicknesses can prevent the peeling off or destruction of the porous region prior to the separation step.

BRIEF DESCRIPTION OF THE DRAWINGS

Figs. 1A, 1B, 1C and 1D are schematic cross-sectional views showing a basic process for producing a semiconductor substrate of the present invention;

Figs. 2A, 2B, 2C, 2D and 2E are schematic cross-sectional views showing an embodiment of the process for producing a semiconductor substrate of the present invention;

Figs. 3A, 3B, 3C, 3D and 3E are schematic cross-sectional views showing another embodiment of the process for producing a semiconductor substrate of the present invention;

Figs. 4A, 4B, 4C, 4D and 4E are schematic cross-sectional views showing still another embodiment of the process for producing a semiconductor substrate of the present invention;

Fig. 5 is a chart showing the relationship between the anodizing time and the anodizing current of the anodization employed in the present invention;

Fig. 6 is a chart showing the relationship between the thickness of the first porous layer and the anodizing current for forming the second porous layer; and

Fig. 7 is a chart showing the relationship between the thickness of the first porous layer and the porosity of the second porous layer.

## DETAILED DESCRIPTION OF THE PREFERRED EMBODIMENTS

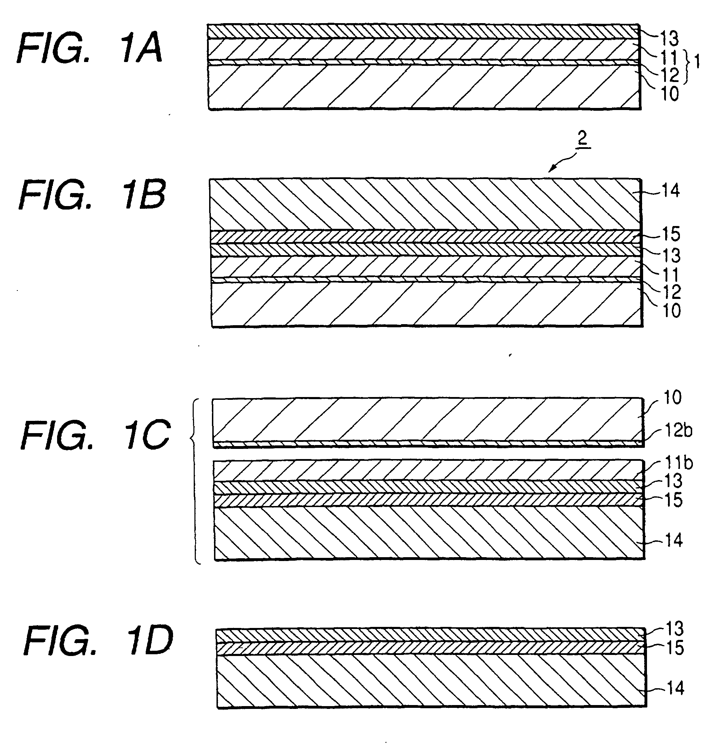

In the following there will be explained a basic process for producing a semiconductor substrate according to the present invention, with reference to Figs. 1A to 1D.

At first, as shown in Fig. 1A, there is prepared a first substrate 10 provided with a porous region 1 and a non-porous semiconductor layer 13 provided on the porous region 1.

The porous layer 1 is so formed as to have a structure including at least a first porous layer 11 adjacent to the non-porous semiconductor layer 13 and a second porous layer 12.

The porosity P2 of the second porous layer 12 is so selected as to be higher than the porosity P1 of the first porous layer 11, and the porosity P2 is selected within a range from 30% to 60%.

Also the thickness t2 of the second porous layer 12 is so selected as not to exceed 80% of the thickness t1 of the first porous layer 11.

Then, as shown in Fig. 1B, the first substrate 10 and a second substrate 14 are bonded to each other via an insulating layer 15 to obtain a composite member 2 for forming the semiconductor substrate.

The insulating layer 15 is preferably formed, prior to the bonding, on at least either of the surfaces of the first substrate 10 and the second substrate 14.

Then, as shown in Fig. 1C, the first and the second substrates are separated, whereupon the separation takes place at the interface of the first porous layer 11 and the second porous layer 12, or at a portion of the second porous layer close to the above-mentioned interface, or at a portion including the entire second porous layer.

Thus, a remnant layer 11b of a uniform thickness resulting from the first porous layer 11 remains on the second substrate. On the other hand, on the first substrate, there may or may not remain a remnant layer 12b of the second porous layer 12.

Then, as shown in Fig. 1D, the first porous semiconductor layer 11b remaining on the surface of the second substrate 14, namely on the non-porous semiconductor layer 13 is removed. In this manner there is obtained a SOI substrate having the non-porous semiconductor layer 13 on the second substrate 14 via the insulating layer 15.

Also by removing, if necessary, the second porous layer 12b remaining on the first substrate 10, the separated first substrate 10 can be used again as the first or second substrate.

The starting material for the first substrate prior to the formation of the porous region 1 is preferably selected from semiconductor materials such as Si, Ge, GaAs, InP, SiC or SiGe.

The porous region may either be formed by making the surface of the starting material porous or be additionally formed on the surface of the starting material.

The porosity P (%) indicates the proportion of volume of the pores, within the volume of the porous layer, with respect to the material constituting the porous layer. The porosity is represented as follows, by using the density m of the porous member and the density M of a non-porous member of the same material as that of the porous member:

$$P = ((M - m)/M) \times 100 \ (\%) \tag{1}$$

The density m of the porous member is obtained by dividing the apparent weight G of the porous member, containing pores, by the apparent volume V of the porous member containing the pores, namely m = G/V.

In practice, the porosity P (%) of the porous layer of the first substrate of which the surface layer only down to a depth d from the surface is porous is determined by:

$$P = ((A - a)/(A - B)) \times 100 \ (\%) \tag{2}$$

wherein A is the weight of the first substrate prior to the formation of the porous layer, a is the weight of the first substrate after the formation of the porous layer, and B is the weight of the first substrate after complete removal of the porous layer.

It is desirable to maintain the porosity of the first porous layer, adjacent to the non-porous semiconductor layer, as low as possible, in order to decrease the crystal defects in the non-porous semiconductor layer at the subsequent formation thereof. The reason is that at the initial period of the formation of the non-porous semiconductor layer on the porous region, the pores in the porous region are filled, and, the lower the porosity, the easier the pore filling, with the result that the crystal defects of the non-porous semiconductor layer can be reduced. For this purpose the porosity of the first porous layer is desirably less than 30%, preferably not more than 20%.

Also in order to more easily realize the separation of the bonded substrates, the porosity of the second porous layer is desirably selected to be not less than 30%, more preferably not less than 40%, and to be not more than 60%. Such selection is to reduce the portion constituting the walls of the pores in the porous layer, thereby rendering the porous structure more fragile and facilitating the destruction thereof at that portion.

The second porous layer can be made thin, for the purpose of separation of the bonded substrates. A thickness of at least 50 nm, preferably at least 100 nm, is effective for the separation of the substrates. However an excessively small thickness leads to a difficulty in the precise control of the thickness of the second porous layer.

On the other hand, an excessively large thickness of the second porous layer may result in peeling off of the first porous layer prior to the bonding, even if the porosity of the second porous layer is not so high. In order to prevent such peeling, it is effective to form the second porous layer thinner than the first porous layer. As an internal stress is generated in the portion of a lower porosity, the portion of a higher porosity, if formed thicker than the portion of the lower porosity, becomes excessively weak and may be broken prior to the bonding whereby the portion of the lower porosity may be peeled off. Even if the first porous layer is considerably thick, it is not desirable to form the second porous layer thicker than 3 $\mu$m. Consequently the thickness of the second porous layer is so selected as not to exceed 3 $\mu$m. More specifically, in consideration of the ease of separation, the thickness of the second porous layer is selected within a range from 1 nm to 1 $\mu$m for a substrate not exceeding 150 mm (6 inches in diameter), and within a range from 1 to 3 $\mu$m for a substrate of 200 mm (8 inches) or larger in diameter.

If necessary, there may be further provided a layer of a porosity between those of the first and the second porous layers, between the first and the second porous layers or at a side of the second porous layer opposite to the first porous layer. The stress at the separation is concentrated on a layer of the highest porosity, which thus functions as the second porous layer.

In the following there will be given a detailed explanation, taking silicon as an example. The mechanical strength of porous Si, though being dependent on the level of porosity, is considered sufficiently lower than that of bulk Si. Thus, if the bonded wafers are given a compressing, pulling or shearing force, the porous Si layer is broken at first. The porous layer can be broken with a weaker force with the increase in the level of porosity. If the porous layer is composed of a plurality of layers of different porosities, the stress will be concentrated in a layer of the highest porosity, where the destruction begins.

An Si substrate can be made porous by anodization utilizing an HF solution. In comparison with the density 2.33 g/cm$^3$ of single-crystal Si, the density of the porous Si layer can be varied within a range of 1.1-0.6 g/cm$^3$ by a change of the concentration of the HF solution within a range of 50-20%. The porous layer is not easily formed in an N-type Si layer but easily formed in a P-type Si substrate because of the reason explained below. According to the observation with a transmission electron microscope, the porous Si layer contains pores of 10 - 60 nm (100-600 Å) in average diameter.

The porous Si was found by Uhlir et al. in 1956 in the course of investigation of electropolishing of semiconductor (A. Uhlir, Bell Syst. Tech. J., Vol. 35, 333 (1956)).

Also Unagami et al. investigated the dissolution reaction of Si in anodization and reported that the anodizing reaction of Si in an HF solution involved positive holes with the following reactions schema (T. Unagami, J. Electrochem. Soc., Vol. 127, 476 (1980):

$$Si + 2HF + (2-n)e^+ \rightarrow SiF_2 + 2H^+ + ne^- SiF_2 + 2HF$$

$$\rightarrow SiF_4 + H_2$$

$$SiF_4 + 2HF \rightarrow H_2SiF_6$$

or

$$Si + 4HF + (4-\lambda)e^+ \rightarrow SiF_4 + 4H^+ + \lambda e^- SiF_4 + 2HF$$

$$\rightarrow H_2SiF_6$$

wherein e$^+$ and e$^-$ respectively represent a positive hole and an electron. Also n and $\lambda$ indicate the number of positive holes required for dissolving a Si atom, and it was reported the porous Si was formed when a condition n > 2 or $\lambda$ > 4 is satisfied.

According to the above, the P-type Si containing positive holes can be made porous but the N-type Si is not made so. This selectivity in porous structure formation was proved by Nagano et al. and Imai (Nagano, Nakajima, Yasuno, Ohnaka and Kajiwara, Technical Research Report of Electronic Communications Society, Vol. 79, SSD79-9549 (1979), K. Imai, Solid-State Electronics, Vol. 24, 159 (1981)). It is however also reported that porous structure formation is possible in the n-type Si if the impurity concentration is high (R. P. Holmstrom and J. Y. Chi, Appl. Phys. Lett., Vol. 42, 386 (1983)), so that it is important to select a substrate allowing porous structure formation, regardless of P or N type.

By the observation with a transmission electron microscope, the porous Si layer contains pores of about 10 - 60 nm (100-600 Å) in average diameter. The single-crystallinity is maintained even when the density is reduced less than half of that of single-crystal Si, so that it is possible to epitaxially grow a single-crystal Si layer on the porous layer. However, at a temperature exceeding 1000°C, the internal pores are rearranged to deteriorate the accelerated etching characteristics. For this reason, a low-temperature growth method such as molecular beam epitaxial growth, plasma CVD, low pressure CVD, photo CVD, bias sputtering or liquid phase growth is considered adequate for the epitaxial growth of the Si layer.

Also as the porous layer has a large amount of voids formed therein, its density is reduced to less than half. As a result, the surface area increases drastically in comparison with the volume, so that the chemical etching rate thereof is significantly increased in comparison with that of the ordinary single-crystal layer.

The non-porous semiconductor layer to be employed in the present invention consists of a single layer or plural layers of a semiconductor such as Si, Ge, GaAs, InP, SiC, SiGe, GaN or GaP. In case of plural layers, the respective layers may be different from each other in conductivity type or electric conductivity, or may be those which form a hetero junction therebetween.

The non-porous semiconductor layer may be formed by depositing a non-porous semiconductor layer on the porous region, or by forming a porous layer, for example by ion implantation, under the surface layer of a non-porous starting material, and employing the surface layer, which remains without being made porous state, as the non-porous semiconductor layer.

The second substrate employed in the present invention may be selected from semiconductors such as Si, Ge, SiC, SiGe, GaAs or InP, or from insulating materials such as quartz, fused quartz, silica glass, glass, sapphire or the like.

As the method for separating the bonded substrates, there may be employed any of the separation methods disclosed in Japanese Patent Application Laid-Open No. 7-302889, for example irradiation with wave energy such as ultrasonic wave, insertion of a separating member from a side surface of the porous layer parallel to the bonded surface of the bonded substrates, utilization of expanding energy of a material impregnated in the porous layer, selective etching of the porous layer from a side surface of a disk-like substrate, or exposing the porous layer and oxidizing the porous layer from a side surface thereof and utilizing the volume expansion at the oxidation.

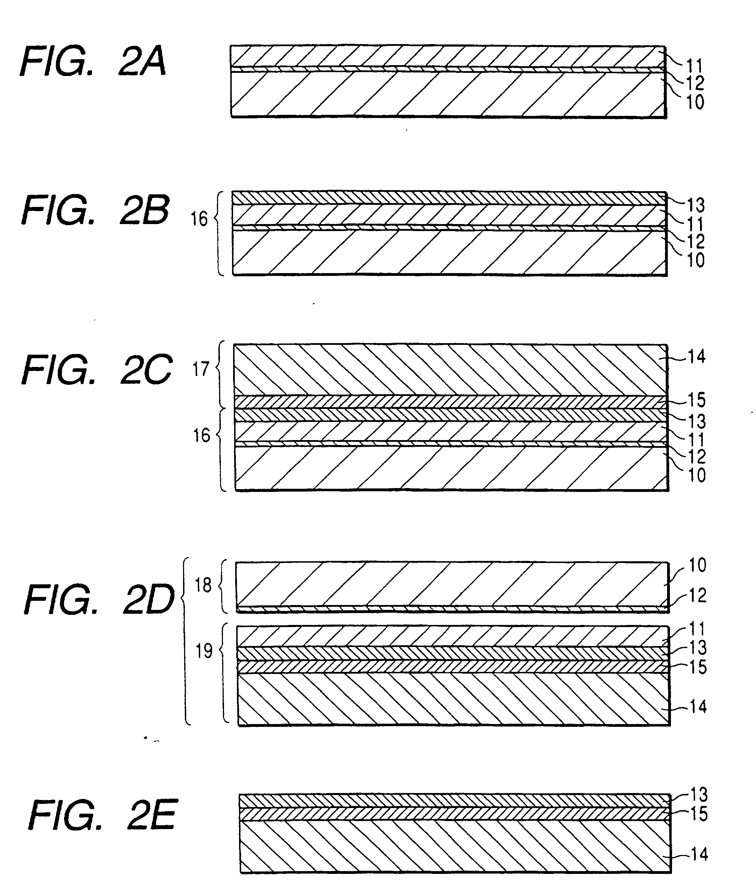

Figs. 2A to 2E show a process for producing a semiconductor substrate, based on the basic process shown in Figs. 1A to 1D and constituting an embodiment of the present invention.

As shown in Fig. 2A, on the surface of a first substrate 10, there are formed a first porous layer 11 and a second porous layer 12. The porosity of the second porous layer 12 is selected to be not less than 30%, while that of the first porous layer 11 is selected to be less than 30%. Also the thickness of the second porous layer 12 is so selected as to be not more than 0.8 times of that of the first porous layer 11.

The first and the second porous layers as defined above can be advantageously formed by anodization. After the first porous layer 11 is formed, on the surface of the first substrate 10, with a first anodizing current, the current is increased to make porous the non-porous portion of the first substrate under the first porous layer, thereby forming the second porous layer 12. Instead of increasing the current, the anodizing liquid may be replaced to form the second porous layer 12 by the anodization under the same current.

Then, as shown in Fig. 2B, a non-porous semiconductor layer 13 is formed on the porous layer 11, and the surface of the non-porous semiconductor layer 13 is made insulating, if necessary.

Then, as shown in Fig. 2C, a support substrate 17 having a second substrate 14 and bearing an insulating layer 15 thereon and a substrate 16 having the first substrate 10 bearing the above-described layers 11, 12, 13 are brought into close contact with each other at room temperature, and the substrates are bonded to each other by anodic bonding, pressure application, heat treatment or a combination thereof.

Thus the second substrate 14 and the non-porous semiconductor layer 13 are firmly bonded via the insulating layer 15. The insulating layer 15 is formed on at least either of the non-porous semiconductor layer 13 and the second substrate 14. Otherwise the bonding may be made with three members, including an insulating thin plate.

Then the bonded members are separated into a substrate 18 and a substrate 19 at the porous Si layer 12 as shown in Fig. 2D. The substrate 19 is composed of the first porous layer 11, the non-porous semiconductor layer 13, the insulating layer 15 and the substrate 14.

Then the porous layer 11 is selectively removed. The porous layer 11 alone is etched off by electroless wet chemical etching with at least one of an ordinary Si etching solution, hydrofluoric acid which is selective etching liquid for porous Si, a mixture of hydrofluoric acid and at least either of alcohol and aqueous hydrogen peroxide solution, buffered hydrofluoric acid and a mixture of buffered hydrofluoric acid and at least either of alcohol and aqueous hydrogen peroxide solution, thereby leaving and forming the non-porous semiconductor layer 13 transferred onto the insulating layer 15 (Fig. 2E).

Otherwise there may be conducted selective polishing to remove the porous layer 11, utilizing the non-porous semiconductor layer 13 as the polishing stopper.

Fig. 2E shows the semiconductor substrate obtained by the present invention, wherein, on the substrate 14 with an insulating surface, the non-porous semiconductor layer 13 is formed as a flat and uniform thin layer, with few crystal defects.

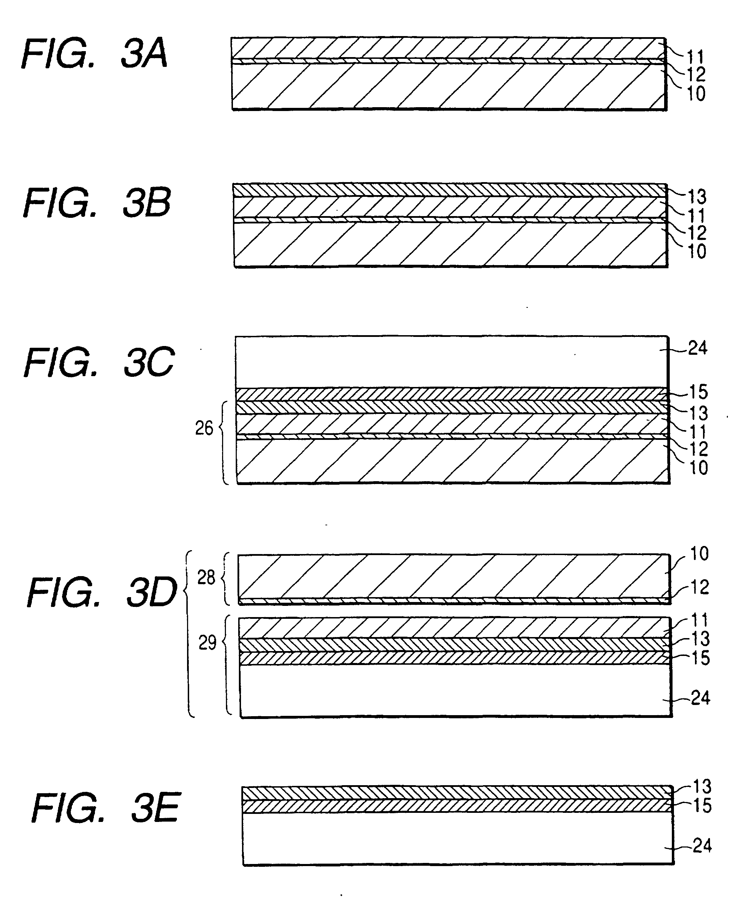

Figs. 3A to 3E show a variation of the semiconductor substrate producing process shown in Figs. 2A to 2E, employing a light-transmissive insulating substrate as the second substrate. The steps shown in Figs. 3A and 3B are the same as those shown in Figs. 2A and 2B.

Then, as shown in Fig. 3C, a light-transmissive insulating substrate 24 represented by quartz or glass and a first substrate 26 are brought into close contact with each other at room temperature, and the substrates are mutually bonded to each other by anodic bonding, pressure application, heat treatment or a combination thereof. Thus the light-transmissive insulating substrate 24 and the non-porous semiconductor layer 13 are firmly bonded to each other via the insulating layer 15. The insulating layer 15 is formed on at least either of the non-porous semiconductor layer 13 and the light-transmissive insulating substrate 24. Otherwise the bonding may be made with three members, including an insulating thin plate.

Then, as shown in Fig. 3D, the bonded members are separated into a substrate 28 and a substrate 29. On the light-transmissive insulating substrate 24 there is formed a multi-layered structure consisting of the first porous layer 11, the non-porous semiconductor layer 13 and the insulating layer 15.

Then the porous layer 11 is selectively removed. The porous layer 11 alone is etched off by electroless wet chemical etching with at least one of ordinary Si etching liquid, hydrofluoric acid which is selective etching liquid for porous Si, a mixture of hydrofluoric acid and at least either of alcohol and aqueous hydrogen peroxide solution, buffered hydrofluoric acid, and a mixture of buffered hydrofluoric acid and at least either of alcohol and aqueous hydrogen peroxide solution, thereby leaving and forming the non-porous semiconductor layer 13 on the light-transmissive insulating substrate 24. Because of the very large surface area of the porous member as described above, it is possible to selectively etch the porous member only and to leave the non-porous member even with the ordinary etching liquid.

Otherwise there may be conducted selective polishing to remove the porous layer 11, utilizing the non-porous semiconductor layer 13 as the polishing stopper.

Fig. 3E shows the semiconductor substrate obtained by the present invention, wherein, on the surface of the light-transmissive insulating substrate 24, the non-porous semiconductor layer 13 is formed as a flat and uniform thin layer with a large area, over the entire region of the substrate.

Then, for the purpose of recycling, or reusing, the first substrate 10 is subjected to removal of the remaining porous layer 12 and, if the surface flatness is unacceptably coarse, additionally to the surface flattening treatment, and is used again as the first substrate 10.

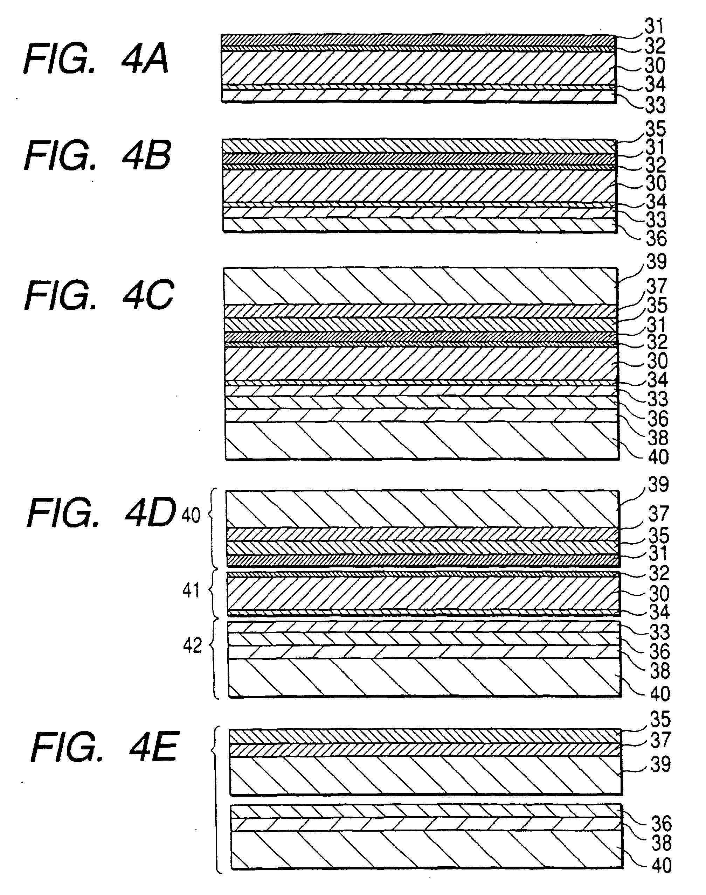

Figs. 4A to 4E show a process of forming a porous layer and a non-porous semiconductor layer on each surface of a substrate and bonding three substrates.

At first, as shown in Fig. 4A, a first substrate 30 is prepared, and, in the surface portions on the both surfaces, there are formed two-layer-structure porous regions consisting of two layers 31, 32 and 33, 34 of different porosities, respectively and there are further formed non-porous semiconductor layers 35, 36 on the first porous layers 31, 32 (see Fig. 4B). The anodization is so conducted that the first porous layers 31, 33 have a porosity less than 30% while the second porous layers 32, 34 have a porosity not less than 30%.

Thus, as shown in Fig. 4C, two second substrates 39, 40 and the first substrate 30 having the non-porous semiconductor layers 35, 36 are brought into close contact with each other at room temperature respectively via insulating layers 36, 37, and the substrates are mutually bonded to each other by anodic bonding, pressure application, heat treatment or a combination thereof.

Thus the substrates 39, 40 and the non-porous semiconductor layers 35, 36 are firmly bonded via the insulating layers 37, 38. The insulating layers 37, 38 are formed on at least either of the non-porous semiconductor layers 35, 36 and the substrates 39, 40. Otherwise separate insulating thin plates are prepared as the layers 35, 36 and inserted between the substrates to achieve the bonding with five members.

Then the bonded members are separated into three members 40, 41, 42 (see Fig. 4D), wherein each of the substrates 39, 40 has a stacked structure consisting of the porous layer, the non-porous semiconductor layer and the insulating layer.

Then the porous layers 31, 33 are selectively removed by polishing or etching, whereby thin non-porous semiconductor layers 35, 36 are left on the substrates 39, 40.

Fig. 4E shows the semiconductor substrates obtained by the present invention, wherein, on the substrates 39, 40, the non-porous semiconductor layers 35, 36 are formed at the same time as flat and uniform thin layers. The intermediate insulating layers 37, 38 may be omitted, and the substrates 39, 40 need not be of the same material.

Then, for the purpose of recycling or reusing, the first substrate 30 is subjected to removal of the remaining porous layer or to the surface flattening treatment, and is used again.

In the following there will be explained, of the methods for forming the porous region applicable in the present invention, the process based on anodization.

The porosity of the porous layer can be varied in the direction of thickness for example by a change in the anodizing current in the course of anodization for forming the porous layer, or by a change in the concentration of the anodizing liquid. The porosity and the pore size of the porous layer can be varied by a change in the concentration of an anodizing liquid using HF or in the anodizing current, as disclosed in SOLID-STATE SCIENCE AND TECHNOLOGY, Journal of Electrochemical Society, Vol. 134, No. 8, p. 1994. The composition of the anodizing liquid may be changed for example by the subsequent addition of hydrofluoric acid or water. Plural layers different in porosity can be formed, for example by at first forming a porous layer of a low porosity with an anodizing liquid of a high HF concentration, then forming a porous layer of a high porosity by replacing the anodizing liquid with another one of a lower HF concentration. However, according to the investigation of the present inventors, such method, if applied to the separation of the bonded substrates for production of a semiconductor substrate, may result in a more complex phenomenon as will be explained later. Thus the conventional method, if simply followed, can only provide a very limited effect. For example, a mere increase in the anodizing current does not provide a corresponding increase in the porosity but may result in an increased anodizing rate with a limited increase in the porosity. In order to obtain the structure according to the present invention, there can be employed the following process for obtaining the porous layer at a low cost.

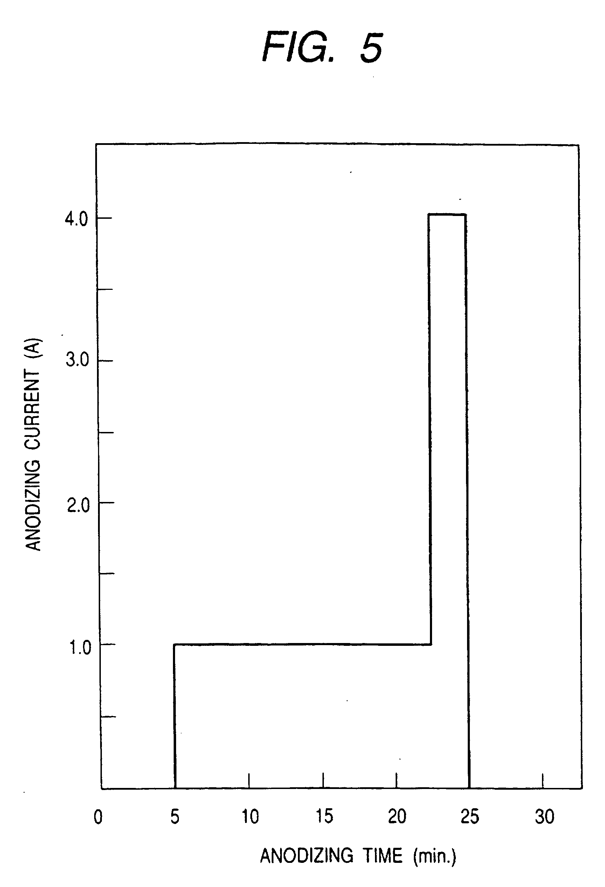

The simplest method in practice is of changing the anodizing current without change in the composition of the anodizing liquid. Various compositions can be employed for the anodizing liquid. For example, satisfactory results can be obtained with hydrofluoric acid containing HF in about 30% or such hydrofluoric acid further added with alcohol. The anodization is conducted in such an anodizing liquid, and porous Si with porosity of 20 to 30% can be formed with a DC anodizing current density of 0.5-1.0 A/cm$^2$ using an Si substrate as the anode. The thickness of the porous Si can be arbitrarily selected depending on the anodizing time, and such a porous Si layer of a relatively low porosity is adequate for epitaxially growing thereon single-crystal Si. After the formation of the porous layer of such a relatively low porosity, the current is increased to form a porous layer of a higher porosity. Fig. 5 shows an example of the mode of current variation. When the first porous layer has a porosity of about 20% and a thickness of about 10 µm, the second porous layer with a porosity of about 30 to 60% can be formed under the first porous layer, by setting the anodizing current to 2 to 3 times of that for forming the first porous layer.

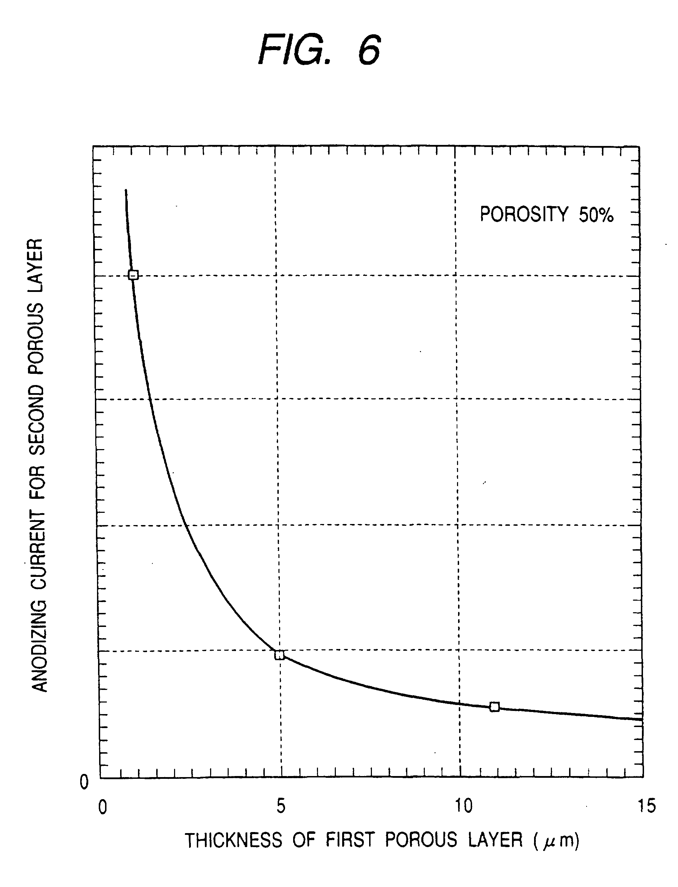

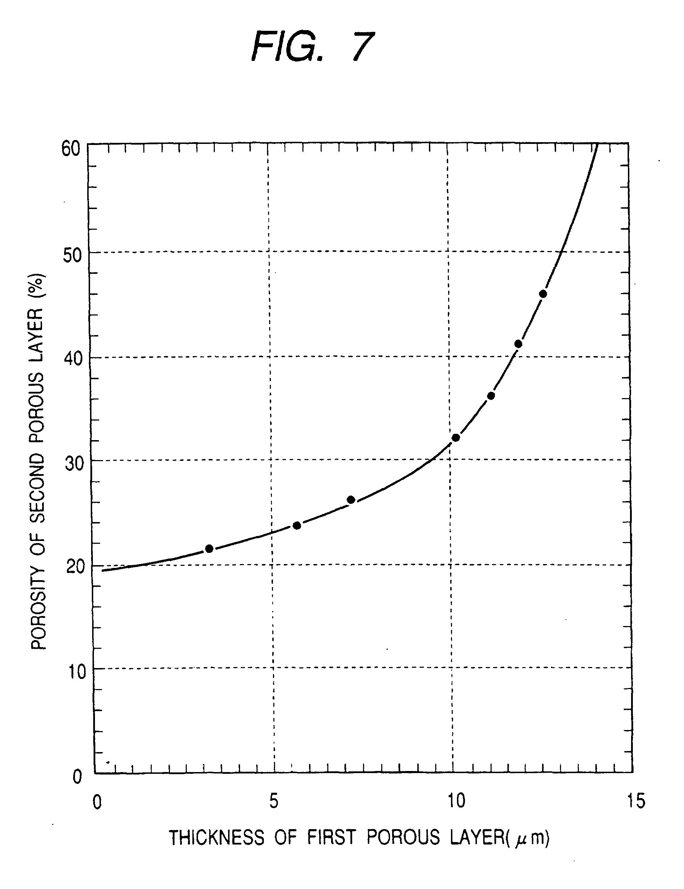

Based on the intensive investigation, the present inventors have found that the porosity of the second porous layer is dependent not only on the magnitude of the anodizing current but also on the thickness and porosity of the first porous layer. Even when the anodizing current for the second porous layer is set to be the same as that for the first porous layer, if the first porous layer has a larger thickness or lower porosity, the porosity of the second porous layer tends to become higher. Consequently, if the first porous layer is made thinner, the anodizing current for the second porous layer has to be made higher in order to maintain a high porosity level therein. This relationship is shown in Fig. 6. If the anodizing current for the second porous layer is maintained constant, the porosity of the second porous layer is affected by the change in the thickness of the first porous layer. This relationship is shown in Fig. 7. It will be evident that the formation of the second porous layer after the formation of the first porous layer cannot be independent therefrom but the porosity of the second porous layer is affected by the characteristics of the first porous layer. The detailed mechanism of such phenomenon is not yet fully clarified. However, as will be explained later, the formation of the porous Si is considered to require F$^-$ ions in the anodizing liquid, and, as F$^-$ ions are consumed in a pore forming portion at the front end of a pore, new F$^-$ ions have to be transported through the pore and supplied to such front end portion. The effective mobility of F$^-$ ions by transportation through the pore by an electric field or by diffusion is considered to depend on the pore size of the first porous layer or the length of pore, namely the thickness of the first porous layer. Stated differently, the first porous layer itself formed by anodization limits the ion transportation required in the formation of a subsequent porous layer. Consequently, the formed first porous layer functions as a layer for limiting the effective mobility of the F$^-$ ion transportation required for the subsequent porous layer formation. Under a constant anodizing current, the anodization proceeds to a considerable thickness without a significant change in the porosity. This is presumably because, under a constant current, the pores are formed with a size determined by the balance of consumption and supply of F$^-$ ions but, if the current is increased in the course of anodization, the balance of consumption and supply of F$^-$ ions is changed by the presence of an already formed porous layer, thereby resulting in a significant change in the pore size.

When the first porous layer becomes thicker to reduce the effective mobility of F$^-$ ions transported therein, there is a possibility that the F$^-$ ion concentration at the front end of the pore may become lower to expand an ion depletion layer in the anodizing liquid in the pore, whereby the portion may spread in which the potential barrier at the interface between the anodizing liquid and the single crystal Si surface in the pore become lower, thereby inducing etching of Si in such a portion to increase the pore size. In fact, a mere increase in the anodizing current does not cause a significant increase in the porosity but induces an increase in the anodizing rate unless a mobility limiting layer is present on the Si surface. Consequently, in order to obtain a significant change in the porosity by an increase in the anodizing current, there is required a layer capable of limiting the mobility of F$^-$ ions between the anodizing liquid and the layer of which porosity is to be increased. The present invention is featured also by making the most of the above-described mechanism of anodization, utilizing the initially formed first porous layer for attaining increase of the porosity of the second porous layer. In order to increase the porosity of the second porous layer, the first porous layer is required to have a certain thickness, and a high-porosity second porous layer can be easily formed when the first porous layer is 5 $\mu$m or more in thickness.

As the first porous layer has such function, the control of the thickness thereof is important for the porosity control of the second porous layer. For example the in-plane-uniformity of the first porous layer has to be secured sufficiently, since otherwise the porosity of the second porous layer fluctuates in plane. The presence of in-plane-fluctuation of the porosity of the second porous layer results in local fluctuation of the strength of the second porous layer, eventually leading to a partial peeling off of the second porous layer in the course of the SOI wafer production process or a locally incomplete separation at the separation step, whereby the production yield of the SOI wafer is lowered. The fluctuation within the substrate plane in thickness of the first porous layer has to be 35% or less, preferably 25% or less.

When the thickness of the first porous layer is made significantly less than 5 $\mu$m, in particular not more than 3 $\mu$m, the increase in porosity becomes progressively difficult since the effect of the mobility limiting layer described above is reduced. As shown in Fig. 6, as the first porous layer becomes thinner, the anodizing current for the second porous layer has to be increased infinitely. Such increase in the current is naturally not impossible, but involves certain sacrifices such as an increase in the required power supply capacity, a resulting lowering in the precision of current control and a decrease in the precision of current measurement. Also an increased current leads to a higher anodizing rate, with possible lowering in the precision in the thickness control of the second porous layer. In such a case, all the requirements need not be satisfied by the current control only. A lowered HF concentration in the anodizing liquid can facilitate the decrease of F$^-$ ion concentration at the front end of the pore. In the formation of the first porous layer at first, the above-mentioned mobility limiting layer is still absent, so that sufficiently reducing the anodizing current can sufficiently supply the consumed F$^-$ ions, even if the HF concentration is lowered by a certain extent, and the porosity therefore scarcely increases. For example, even when the HF concentration is lowered to about HF : $C_2H_5OH$ : $H_2O$ = 1 : 1 : 4, the porosity can be suppressed at about 20% if the anodizing current is limited to about 1 mA/cm$^2$ or less. After the formation of the first porous layer, the above-mentioned mobility limiting layer is already present, so that the deficiency in F$^-$ ions can be created at the front end of the pore even with a limited increase of the anodizing current, whereby the porosity can be increased. Thus, even after the formation of the above-described first porous layer of a thickness of 3 $\mu$m, there can be formed the second porous layer with a porosity as high as 30-60% by a mere increase of the anodizing current to about 5 mA/cm$^2$. On the other hand, if the HF concentration in the anodizing liquid is higher and is about HF : $C_2H_5OH$ : $H_2O$ = 1 : 1 : 1, there is required a current of about 10 mA/cm$^2$ or higher in order to elevate the porosity of the second porous layer to 30-60%.

On the other hand, in case of forming a two-layered structure of the inverted order, namely a structure in which the first porous layer has higher porosity than that of the second porous layer, the transportation of F$^-$ ions is difficult to be hindered because of the high porosity of the first porous layer, so that the porosity of the first porous layer cannot be elevated by merely inverting the anodizing current for the first porous layer and that for the second porous layer in view of the above described mechanism.

Therefore, in case of forming plural porous layers different in porosity, there can also be adopted the method of varying the composition of the anodizing liquid for each layer. In case of successively forming a first porous layer of a low porosity with a thickness less than 5 $\mu$m and a second porous layer of a higher porosity by a change in the anodizing current only, it is necessary, as explained in the foregoing, to adopt a relatively large anodizing current for the second porous layer. It is nevertheless possible to form a second porous layer with a porosity of 30 to 60% or even higher without an extreme increase in the anodizing current by at first forming the first porous layer in an anodizing bath with a high HF concentration, then interrupting the anodization, taking out the substrate from the anodizing liquid, replacing the anodizing liquid in the tank with another anodizing liquid with a low HF concentration, immersing the substrate into the anodizing liquid of the low HF concentration and effecting anodization.

In case the anodization is interrupted as mentioned above, the substrate may be cleaned to remove the anodizing liquid depositing thereon or may be dried during such interruption.

The present invention will be described in more detail by the following examples thereof.

Example 1

A 125 mm (5") diameter p-type Si wafer having a thickness of 625 $\mu$m and a specific resistivity of 0.01 $\Omega$cm was prepared as the first substrate. It was subjected to anodization in an HF solution under the following conditions, whereby obtained was a two-layered porous Si region consisting of two layers 11, 12 which were different in porosity:

| Current density | 7 mA/cm$^2$ |
|---|---|
| Anodizing solution | HF : H$_2$O :C$_2$H$_5$OH = 1 : 1 : 1 |
| Time | 11 minutes |
| Porous Si thickness | 10 $\mu$m |
| Porosity | 15% |

then;

| Current density | 25 mA/cm$^2$ |
|---|---|
| Anodizing solution | HF : H$_2$O : C$_2$H$_5$OH = 1 : 3 : 2 |
| Time | 20 seconds |
| Porous Si thickness | 200 nm |
| Porosity | 55% |

This Si wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 $\mu$m by CVD on the porous Si, thereby forming a non-porous single-crystal Si layer on the porous Si, under the following growing conditions:

| Source gas | SiH$_4$ |
|---|---|
| Carrier gas | H$_2$ |
| Temperature | 850°C |
| Pressure | 1.3 Pa |
| Growing rate | 3.3 nm/sec |

Then, on the epitaxial Si layer surface, there was formed an SiO$_2$ layer of a thickness of 100 nm by thermal oxidation.

Separately a Si wafer was prepared as the second substrate and its surface was thermally oxidized.

The surface of the SiO$_2$ layer of the first wafer and the surface of a separately prepared second Si wafer having formed an SiO$_2$ layer of a thickness of 500 nm thereon, were superposed, brought into contact with each other and bonded to each other by heat treatment for 2 hours at 700°C.

The porous layer was made to be exposed at the edge surface of the wafers and the porous Si at the edge portion was removed by a certain amount by etching, and a sharp-edged plate such as a razor blade was inserted therein, whereby the wafers were separated by the destruction of the porous Si layer and the porous Si was exposed.

Thereafter the porous Si layer was selectively etched with an HF/H$_2$O$_2$/H$_2$O etching solution, whereby the porous Si layer was completely removed.

The etching rate of the non-porous Si single-crystal in the above-mentioned etching solution was extremely low so that the non-porous layer only showed a practically negligible film thickness reduction.

In this manner there could be obtained, on the Si oxide film, a single-crystal Si layer of a thickness of 0.2 pm, which was not affected at all by the selective etching of the porous Si.

The cross-sectional observation with a transmission electron microscope confirmed that the Si layer did not show introduction of any new crystal defects and maintained satisfactory crystallinity. Also similar results could be obtained even without formation of the oxide film on the surface of the epitaxial Si layer.

The first Si wafer was subjected to removal of the remaining porous Si and was used again as the first substrate.

Example 2

A 125 mm (5") p-type Si wafer having a thickness of 625 $\mu$m and a specific resistivity of 0.01 $\Omega$cm was prepared as the first substrate. It was subjected to anodization in an HF solution under the following conditions, thereby forming in the surface layer of the first Si wafer a two-layered porous Si region consisting of the following two layers different in porosity:

| Current density | 7 mA/cm$^2$ |
|---|---|

(continued)

| Anodizing solution | HF : $H_2O$ :$C_2H_5OH$ = 1 : 1 : 1 |
|---|---|
| Time | 5 minutes |
| Porous Si thickness | 5 μm |
| Porosity | 15% |

then;

| Current density | 38 mA/cm$^2$ |
|---|---|
| Anodizing solution | HF : $H_2O$ : $C_2H_5OH$ = 1 : 3 : 2 |
| Time | 10 seconds |
| Porous Si thickness | 250 nm |
| Porosity | 50% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 μm by CVD on the porous Si, under the following growing conditions:

| Source gas | $SiH_4$ |
|---|---|
| Carrier gas | $H_2$ |
| Temperature | 850°C |
| Pressure | 1.3 Pa |
| Growing rate | 3.3 nm/sec |

Then, on the epitaxial Si layer surface, there was formed an $SiO_2$ layer of a thickness of 100 nm by thermal oxidation. The surface of the above-mentioned $SiO_2$ layer and the surface of a separately prepared second Si wafer, having an $SiO_2$ layer of a thickness of 500 nm formed thereon, were superposed, brought into close contact with each other and bonded to each other by heat treatment for 2 hours at 700°C.

The porous layer was made to be exposed at the edge surface of the wafers and the porous Si at the edge portion was removed by a certain amount by etching, and a sharp-edged plate such as a razor blade was inserted therein, whereby the wafers were separated by the destruction of the porous Si layer and the porous Si was exposed.

Thereafter the porous Si layer was selectively etched with an $HF/H_2O_2/H_2O$ etching solution, whereby the porous Si layer was completely removed.

The etching rate of the non-porous Si single-crystal in the above-mentioned etching solution was extremely low so that the non-porous layer only showed a practically negligible film thickness reduction.

In this manner there could be obtained, on the Si oxide film of the second wafer, a single-crystal Si layer of a thickness of 0.2 μm, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer. The first wafer was subjected to the removal of the remaining porous Si and was used again as the first substrate.

Example 3

A 125 mm (5") p-type Si wafer having a thickness of 625 μm and a specific resistivity of 0.01 Ωcm was prepared as the first substrate. It was subjected to anodization in an HF solution under the following conditions, thereby forming a two-layered structure porous Si region consisting of the following two layers different in porosity:

| Current density | 7 mA/cm$^2$ |
|---|---|
| Anodizing solution | HF : $H_2O$ :$C_2H_5OH$ = 1 : 1 : 1 |
| Time | 1 minute |
| Porous Si thickness | 1 μm |
| Porosity | 15% |

then;

| Current density | 160 mA/cm$^2$ |
|---|---|
| Anodizing solution | HF : H$_2$O : C$_2$H$_5$OH = 1 : 3 : 2 |
| Time | 5 seconds |
| Porous Si thickness | 500 nm |
| Porosity | 45% |

This wafer was then oxidized for 1 hour at 400°C in oxygen atmosphere, whereby the internal wall surfaces of the pores in the porous Si were covered with a thermal oxide film. Then a single-crystal Si was epitaxially grown with a thickness of 0.3 μm by CVD on the porous Si under the following growing conditions:

| Source gas | SiH$_4$ |
|---|---|
| Carrier gas | H$_2$ |
| Temperature | 850°C |
| Pressure | 1.3 Pa |
| Growing rate | 3.3 nm/sec |

Then, on the epitaxial Si layer surface, there was formed an SiO$_2$ layer of a thickness of 100 nm by thermal oxidation.

The surface of the above-mentioned SiO$_2$ layer of the first wafer and the surface of a separately prepared second wafer, having an SiO$_2$ layer of a thickness of 500 nm formed thereon, were superposed, brought into close contact with each other and bonded to each other by heat treatment for 2 hours at 700°C.

The porous layer was made to be exposed at the edge surface of the wafers and the porous Si at the edge surface was removed by a certain amount by etching, and a sharp-edged plate such as a razor blade was inserted therein, whereby the wafers were mutually separated by the destruction of the porous Si layer and the porous Si was exposed.

Thereafter the porous Si layer was selectively etched with an HF/H$_2$O$_2$/H$_2$O etching solution, whereby the porous Si layer was completely removed.

The etching rate of the non-porous single-crystal Si in the above-mentioned etching solution was extremely low so that the non-porous layer only showed a practically negligible film thickness reduction.

In this manner there could be obtained, on the Si oxide film, a single-crystal Si layer of a thickness of 0.2 μm, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer. The first wafer was subjected to the removal of the remaining porous Si and was used again as the first substrate.

Example 4

A 125 mm (5") p- or n-type Si wafer having a thickness of 625 μm and a specific resistivity of 0.01 Ωcm was prepared as the first substrate. It was subjected to anodization in an HF solution under the following conditions.

| Current density | 7 mA/cm$^2$ |
|---|---|
| Anodizing solution | HF : H$_2$O :C$_2$H$_5$OH = 1 : 1 : 1 |
| Time | 5 minutes |
| Porous Si thickness | 5 μm |
| Porosity | 15% |

then;

| Current density | 38 mA/cm$^2$ |
|---|---|
| Anodizing solution | HF : H$_2$O : C$_2$H$_5$OH = 1 : 3 : 2 |
| Time | 40 seconds |

(continued)

| Porous Si thickness | 1.2 nm |
|---|---|
| Porosity | 45% |

This wafer was then oxidized for 1 hour at 400°C in oxygen atmosphere, whereby the internal wall surfaces of the pores in the porous Si were covered with a thermal oxide film. Then a single-crystal Si was epitaxially grown with a thickness of 0.3 µm by CVD on the porous Si, under the following growing conditions:

| Source gas | $SiH_4$ |
|---|---|
| Carrier gas | $H_2$ |
| Temperature | 850°C |
| Pressure | 1.3 Pa |
| Growing rate | 3.3 nm/sec |

Then, on the epitaxial Si layer surface, there was formed an $SiO_2$ layer of a thickness of 100 nm by thermal oxidation. The surface of the above-mentioned $SiO_2$ layer and the surface of a separately prepared second wafer having an $SiO_2$ layer of a thickness of 500 nm formed thereon were superposed, brought into close contact with each other and bonded by heat treatment for 2 hours at 700°C.

Plates were bonded, with an adhesive, on both the external surfaces of the bonded wafers, and a sufficient pressure was applied uniformly on such plates in a direction perpendicular to the external surfaces of the bonded wafers, whereby the wafers were mutually separated by the destruction of the porous Si layer and the remaining portion of the porous Si was exposed.

Thereafter the remaining porous Si layer was selectively etched with an $HF/H_2O_2/H_2O$ etching solution, whereby the porous Si layer was completely removed.

The etching rate of the non-porous Si single-crystal in the above-mentioned etching solution was extremely low so that the non-porous layer only showed a practically negligible film thickness reduction.

In this manner there could be obtained, on the Si oxide film of the second wafer, a single-crystal Si layer of a thickness of 0.2 µm, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer. The first wafer was subjected to the removal of the remaining porous Si and was used again as the first substrate.

Example 5

A 125 mm (5") p-type Si wafer having a thickness of 625 µm and a specific resistivity of 0.01 Ωcm was prepared as the first substrate. It was subjected to anodization in an HF solution under the following conditions.

| Current density | 7 mA/cm$^2$ |
|---|---|
| Anodizing solution | HF : $H_2O$ : $C_2H_5OH$ = 1 : 1 : 1 |
| Time | 11 minutes |
| Porous Si thickness | 10 µm |
| Porosity | 15% |

then;

| Current density | 25 mA/cm$^2$ |
|---|---|
| Anodizing solution | HF : $H_2O$ : $C_2H_5OH$ = 1 : 3 : 2 |
| Time | 20 seconds |
| Porous Si thickness | 200 nm |
| Porosity | 55% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 $\mu$m by CVD on the porous Si, under the following growing conditions:

| | |
|---|---|
| Source gas | $SiH_4$ |
| Carrier gas | $H_2$ |
| Temperature | 850°C |
| Pressure | 1.3 Pa |
| Growing rate | 3.3 nm/sec |

Then, on the epitaxial Si layer surface, there was formed an $SiO_2$ layer of a thickness of 100 nm by thermal oxidation. The surface of the above-mentioned $SiO_2$ layer and the surface of a separately prepared second wafer having an $SiO_2$ layer of a thickness of 500 nm formed thereon were superposed, brought into close contact with each other and bonded by heat treatment for 2 hours at 700°C.

The porous layer was made to be exposed at the edge surface of the wafers, then the porous Si was etched by a certain amount, immersed in an ultrasonic cleaning tank filled with pure water and subjected to ultrasonic irradiation, whereby the wafers were mutually separated by the destruction of the porous Si layer and the porous Si was exposed.

Thereafter the wafer was dried and the remaining porous Si layer was selectively etched with an $HF/H_2O_2/H_2O$ etching solution, whereby the porous Si layer was selectively etched and completely removed.

The etching rate of the non-porous Si single-crystal in the above-mentioned etching solution was extremely low so that the non-porous layer only showed a practically negligible film thickness reduction. In this manner there could be obtained, on the Si oxide film, a single-crystal Si layer of a thickness of 0.2 $\mu$m, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer. The first wafer was subjected to the removal of the remaining porous Si and was used again as the first substrate.

Example 6

A 125 mm (5") p-type Si wafer having a thickness of 625 $\mu$m and a specific resistivity of 0.01 $\Omega$cm was prepared as the first substrate. It was subjected to anodization in an HF solution under the following conditions.

| | |
|---|---|
| Current density | 7 mA/cm$^2$ |
| Anodizing solution | HF : $H_2O$ : $C_2H_5OH$ = 1 : 1 : 1 |
| Time | 5 minutes |
| Porous Si thickness | 5 $\mu$m |
| Porosity | 15% |

then;

| | |
|---|---|
| Current density | 38 mA/cm$^2$ |
| Anodizing solution | HF : $H_2O$ : $C_2H_5OH$ = 1 : 3 : 2 |
| Time | 10 seconds |
| Porous Si thickness | 250 nm |
| Porosity | 50% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 $\mu$m by CVD on the porous Si, under the following growing conditions:

| | |
|---|---|
| Source gas | $SiH_4$ |
| Carrier gas | $H_2$ |
| Temperature | 850°C |

(continued)

| Pressure | 1.3 Pa |
|---|---|
| Growing rate | 3.3 nm/sec |

Then, on the epitaxial Si layer surface, there was formed an $SiO_2$ layer of a thickness of 100 nm by thermal oxidation. The surface of the above-mentioned $SiO_2$ layer and the surface of a separately prepared second wafer, subjected to removal of the native oxide film, were superposed, brought into close contact with each other and bonded by heat treatment for 2 hours at 700°C.

The porous layer was made to be exposed at the edge surface of the wafers and the porous Si was etched by a certain amount, and a sharp-edged plate such as a razor blade was inserted therein, whereby the wafers were mutually separated by the destruction of the porous Si layer and the porous Si was exposed.

Thereafter the porous Si layer was selectively etched with an $HF/H_2O_2/H_2O$ etching solution, whereby the porous Si layer was completely removed.

The etching rate of the non-porous Si single-crystal in the above-mentioned etching solution was extremely low so that the non-porous layer only showed a practically negligible film thickness reduction.

In this manner there could be obtained, on the Si oxide film, a single-crystal Si layer of a thickness of 0.2 µm, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer. The first wafer was subjected to the removal of the remaining porous Si and was used again as the first substrate.

Example 7

A 125 mm (5") p-type Si wafer having a thickness of 625 µm and a specific resistivity of 0.01 Ωcm was prepared as the first substrate. It was subjected to anodization in an HF solution under the following conditions.

| Current density | 7 mA/cm$^2$ |
|---|---|
| Anodizing solution | HF : $H_2O$ :$C_2H_5OH$ = 1 : 1 : 1 |
| Time | 5 minutes |
| Porous Si thickness | 5 µm |
| Porosity | 15% |

then;

| Current density | 38 mA/cm$^2$ |
|---|---|
| Anodizing solution | HF : $H_2O$ : $C_2H_5OH$ = 1 : 3 : 2 |
| Time | 10 seconds |
| Porous Si thickness | 250 nm |
| Porosity | 50% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 µm by CVD on the porous Si:

| Source gas | $SiH_4$ |
|---|---|
| Carrier gas | $H_2$ |
| Temperature | 850°C |
| Pressure | 1.3 Pa |
| Growing rate | 3.3 nm/sec |

Then, on the epitaxial Si layer surface, there was formed an $SiO_2$ layer of a thickness of 100 nm by thermal oxidation. The surface of the above-mentioned $SiO_2$ layer and the surface of a separately prepared quartz glass substrate, subjected to oxygen plasma irradiation, were superposed, brought into close contact with each other and bonded by heat treatment for 2 hours at 500°C.

The porous layer was made to be exposed at the edge surface of the wafers and the porous Si at the edge surface was etched by a certain amount, and a sharp-edged plate such as a razor blade was inserted therein, whereby the substrates were mutually separated by the destruction of the porous Si layer and the porous Si was exposed.

Thereafter the porous Si layer was selectively etched with an $HF/H_2O_2/H_2O$ etching solution, whereby the porous Si layer was completely removed.

The etching rate of the non-porous Si single-crystal in the above-mentioned etching solution was extremely low so that the non-porous layer only showed a practically negligible film thickness reduction.

In this manner there could be obtained, on the glass substrate, a single-crystal Si layer of a thickness of 0.2 $\mu$m, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer. The first Si wafer was subjected to the removal of the remaining porous Si and was used again as the first substrate.

Example 8

A first 125mm (5") p-type (100) single-crystal Si wafer having a thickness of 625 $\mu$m and a specific resistivity of 0.01 $\Omega$cm was subjected to anodization in an HF solution under the following conditions.

| Current density | 7 mA/cm$^2$ |
|---|---|
| Anodizing solution | HF : $H_2O$ : $C_2H_5OH$ = 1 : 1 : 1 |
| Time | 11 minutes |
| Porous Si thickness | 10 $\mu$m |
| Porosity | 15% |

The above-mentioned single-crystal Si substrate was taken out from the anodizing apparatus, then washed with water and stored, set again in the anodizing apparatus after replacement of the anodizing liquid therein, and subjected to anodization under the following conditions:

| Current density | 25 mA/cm$^2$ |
|---|---|
| Anodizing solution | HF : $H_2O$ : $C_2H_5OH$ = 1 : 3 : 2 |
| Time | 3 minutes |
| Porous Si thickness | 3 $\mu$m |
| Porosity | 55% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 $\mu$m by CVD on the porous Si:

| Source gas | $SiH_4$ |
|---|---|
| Carrier gas | $H_2$ |
| Temperature | 850°C |
| Pressure | 1.3 Pa |
| Growing rate | 3.3 nm/sec |

Then, on the epitaxial Si layer surface, there was formed an $SiO_2$ layer of a thickness of 200 nm by thermal oxidation. The surface of the above-mentioned $SiO_2$ layer and the surface of a separately prepared Si wafer were superposed, brought into close contact with each other and bonded by heat treatment for 1 hour at 1100°C.

The porous layer was made to be exposed at the edge surface of the wafers and the porous Si was etched by a certain amount, and a sharp-edged plate such as a razor blade was inserted therein, whereby the wafers were mutually separated by the destruction of the porous Si layer and the porous Si was exposed.

Thereafter the porous Si layer was selectively etched with an $HF/H_2O_2/H_2O$ etching solution, whereby the porous Si layer was completely removed.

The etching rate of the non-porous Si single-crystal in the above-mentioned etching solution was extremely low so that the non-porous layer only showed a practically negligible film thickness reduction.

In this manner there could be obtained, on the Si oxide film, a single-crystal Si layer of a thickness of 0.2 $\mu$m, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer.

The first Si wafer was subjected to the removal of the remaining porous Si and was used again as the first substrate.

Example 9

A first 125 mm (5") p-type (100) single-crystal Si wafer having a thickness of 625 $\mu$m and a specific resistivity of 0.01 $\Omega$cm was subjected to anodization in an HF solution under the following conditions.

| | |
|---|---|
| Current density | 7 mA/cm$^2$ |
| Anodizing solution | HF : H$_2$O :C$_2$H$_5$OH = 1 : 1 : 1 |
| Time | 5.5 minutes |
| Porous Si thickness | 10 $\mu$m |
| Porosity | 15% |

Then the HF concentration in the anodizing liquid was varied by the addition of H$_2$O and C$_2$H$_5$OH, and the anodization was conducted under the following conditions to form a layer of different porosity:

| | |
|---|---|
| Current density | 25 mA/cm$^2$ |
| Anodizing solution | HF : H$_2$O : C$_2$H$_5$OH = 1 : 3 : 2 |
| Time | 1 minute |
| Porous Si thickness | 1 $\mu$m |
| Porosity | 55% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 $\mu$m by CVD on the porous Si:

| | |
|---|---|
| Source gas | SiH$_4$ |
| Carrier gas | H$_2$ |
| Temperature | 850°C |
| Pressure | 1.3 Pa |
| Growing rate | 3.3 nm/sec |

Then, on the epitaxial Si layer surface, there was formed an SiO$_2$ layer of a thickness of 100 nm by thermal oxidation. The surface of this layer and the surface of a separately prepared Si wafer were superposed, brought into close contact with each other and bonded by heat treatment for 5 minutes at 1180°C.

The porous layer was made to be exposed at the edge surface of the wafers and the porous Si was etched by a certain amount, and a sharp-edged plate such as a razor blade was inserted therein, whereby the wafers were mutually separated by the destruction of the porous Si layer and the porous Si was exposed.

Thereafter the porous Si layer was selectively etched with an HF/H$_2$O$_2$/H$_2$O etching solution, whereby the porous Si layer was selectively etched and completely removed.

The etching rate of the non-porous Si single-crystal in the above-mentioned etching solution was extremely low so that the non-porous layer only showed a practically negligible film thickness reduction.

In this manner there could be obtained, on the Si oxide film, a single-crystal Si layer of a thickness of 0.2 $\mu$m, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer.

The first Si single-crystal wafer was subjected to the removal of the remaining porous Si and was used again as the first substrate.

Example 10

A first 125 mm (5") p-type (100) single-crystal Si wafer having a thickness of 625 $\mu$m and a specific resistivity of 0.01 $\Omega$cm was subjected to anodization in an HF solution under the following conditions.

| | |
|---|---|
| Current density | 7 mA/cm$^2$ |
| Anodizing solution | HF : H$_2$O : C$_2$H$_5$OH = 1 : 1 : 1 |
| Time | 11 minutes |
| Porous Si thickness | 10 $\mu$m |
| Porosity | 15% |

then;

| | |
|---|---|
| Current density | 25 mA/cm$^2$ |
| Anodizing solution | HF : H$_2$O : C$_2$H$_5$OH = 1 : 1 : 1 |
| Time | 3 minutes |
| Porous Si thickness | 3 $\mu$m |
| Porosity | 40% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 $\mu$m by CVD on the porous Si under the following growing conditions:

| | |
|---|---|
| Source gas | SiH$_4$ |
| Carrier gas | H$_2$ |
| Temperature | 850°C |
| Pressure | 1.3 Pa |
| Growing rate | 3.3 nm/sec |

Then, on the epitaxial Si layer surface, there was formed an SiO$_2$ layer of a thickness of 100 nm by thermal oxidation. The surface of this layer and the surface of a separately prepared Si wafer were superposed, brought into close contact with each other and bonded by heat treatment for 5 minutes at 1180°C.

The porous layer was made to be exposed at the edge surface of the wafers and the porous Si was etched by a certain amount, and a sharp-edged plate such as a razor blade was inserted therein, whereby the wafers were mutually separated by the destruction of the porous Si layer and the porous Si was exposed.

Thereafter the porous Si layer was selectively etched with an HF/H$_2$O$_2$/H$_2$O etching solution, whereby the porous Si layer was selectively etched and completely removed.

The etching rate of the non-porous Si single-crystal in the above-mentioned etching solution was extremely low so that the non-porous layer only showed a practically negligible film thickness reduction.

In this manner there could be obtained, on the Si oxide film, a single-crystal Si layer of a thickness of 0.2 $\mu$m, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer. The first Si single-crystal wafer was subjected to the removal of the remaining porous Si and was used again as the first substrate.

Example 11

A first 125 mm (5") p-type (100) single-crystal Si wafer having a thickness of 625 $\mu$m and a specific resistivity of 0.01 $\Omega$cm was subjected to anodization in an HF solution under the following conditions.

| | |
|---|---|
| Current density | 0.5 mA/cm$^2$ |
| Anodizing solution | HF : H$_2$O :C$_2$H$_5$OH = 1 : 4 : 1 |
| Time | 80 minutes |
| Porous Si thickness | 3 $\mu$m |
| Porosity | 20% |

then;

| | |
|---|---|
| Current density | 5 mA/cm$^2$ |
| Anodizing solution | HF : H$_2$O : C$_2$H$_5$OH = 1 : 4 : 1 |
| Time | 1 minute |
| Porous Si thickness | 1.8 $\mu$m |
| Porosity | 45% |

This wafer was then oxidized for 1 hour at 400°C in oxygen atmosphere, whereby the internal wall surfaces of the pores in the porous Si were covered with a thermal oxide film. Then a single-crystal Si layer was epitaxially grown with a thickness of 0.3 $\mu$m by CVD on the porous Si under the following growing conditions:

| | |
|---|---|
| Source gas | SiH$_4$ |
| Carrier gas | H$_2$ |
| Temperature | 850°C |
| Pressure | 1.3 Pa |
| Growing rate | 3.3 nm/sec |

Then, on the epitaxial Si layer surface, there was formed an SiO$_2$ layer of a thickness of 100 nm by thermal oxidation. The surface of this layer and the surface of a separately prepared Si wafer were superposed, brought into close contact with each other and bonded by heat treatment for 5 minutes at 1180°C.

The porous layer was made to be exposed at the edge surface of the wafers and the porous Si was etched by a certain amount, and a sharp-edged plate such as a razor blade was inserted therein, whereby the wafers were mutually separated by the destruction of the porous Si layer and the porous Si was exposed.

Thereafter the porous Si layer was selectively etched with an HF/H$_2$O$_2$/H$_2$O etching solution, whereby the porous Si layer was selectively etched and completely removed.

The etching rate of the non-porous Si single-crystal in the above-mentioned etching solution was extremely low so that the non-porous layer only showed a practically negligible film thickness reduction.

In this manner there could be obtained, on the Si oxide film, a single-crystal Si layer of a thickness of 0.2 $\mu$m, which was not affected at all by the selective etching of porous Si.

The cross-sectional observation with a transmission electron microscope confirmed that the Si layer did not show introduction of any new crystal defects and maintained satisfactory crystallinity.

Also similar results could be obtained even without formation of the oxide film on the surface of the epitaxial Si layer.

The first Si single-crystal wafer was subjected to the removal of the remaining porous Si and was used again as the first substrate.

Reference Example 1

A 125 mm (5") p-type Si wafer having a thickness of 625 $\mu$m and a specific resistivity of 0.01 $\Omega$cm was prepared and was subjected to anodization in an HF solution under the following conditions.

| | |
|---|---|
| Current density | 7 mA/cm$^2$ |
| Anodizing solution | HF : H$_2$O :C$_2$H$_5$OH = 1 : 1 : 1 |

(continued)

| Time | 11 minutes |
|---|---|
| First porous Si layer thickness | 10 $\mu$m |
| Porosity | 15% |

then;

| Current density | 25 mA/cm$^2$ |
|---|---|
| Anodizing solution | HF : H$_2$O : C$_2$H$_5$OH = 1 : 3 : 2 |
| Time | 20 minutes |
| Second porous Si layer thickness | 13 $\mu$m |
| Porosity | 55% |

This wafer was then oxidized for 1 hour at 400°C in oxygen atmosphere, whereby the internal wall surfaces of the pores in the porous Si were covered with a thermal oxide film.

Thereafter the bonding and separation of the wafers were conducted in the same manner as in Example 8.

As a result, the porous Si layer, which should remain uniformly on the single-crystal Si of the second wafer after separation, showed partial peeling off.

This is presumably because the porous Si layer of the high porosity could not withstand the stress and was broken in the step subjected to heating.

[Reference Example 2]

The surface layer of a first single-crystal Si wafer was made porous by anodization in an HF solution under the following conditions:

| Current density | 7 mA/cm$^2$ |
|---|---|
| Anodizing solution | HF : H$_2$O :C$_2$H$_5$OH = 1 : 1 : 1 |
| Time | 5.5 minutes |
| Porous Si thickness | 6 $\mu$m |

then;

| Current density | 70 mA/cm$^2$ |
|---|---|
| Anodizing solution | HF : H$_2$O : C$_2$H$_5$OH = 1 : 1 : 1 |
| Time | 0.5 minute |
| Porous Si thickness | 5 $\mu$m |

This wafer was then oxidized for 1 hour at 400°C in oxygen atmosphere, whereby the internal wall surfaces of the pores in the porous Si were covered with a thermal oxide film. Then a single-crystal Si was epitaxially grown with a thickness of 0.3 $\mu$m by CVD on the porous Si, under the following growing conditions:

| Source gas | SiH$_4$/H$_2$ |
|---|---|
| Temperature | 850°C |
| Pressure | 1.3 Pa |
| Growing rate | 3.3 nm/sec |

Then, on the epitaxial Si layer surface, there was formed an SiO$_2$ layer of a thickness of 200 nm by thermal oxidation. The surface of this Si layer having the SiO$_2$ layer formed thereon and the surface of a separately prepared Si wafer (second substrate) were superposed, and brought into mutual contact.

Thereafter the wafers were separated in the same manner as in Example 8. After the separation, the thickness of the first porous layer of the low porosity, remaining on the surface of the epitaxial single-crystal Si, which was transferred onto the separated second wafer, was not uniform within the wafer plane, and the porous Si had locally destroyed portions. As a result, after etching with an HF/H$_2$O$_2$/H$_2$O etching solution, the thickness of the epitaxial single-crystal Si layer which should remain with a uniform thickness showed an in-plane distribution inferior to that of a commercially available Si wafer.

[Effect of the Invention]

According to the present invention, there can be provided a composite member for production of a semiconductor substrate, and a process for producing the semiconductor substrate, scarcely generating destruction of the porous region prior to the separation of the substrates and showing excellent reproducibility in the location of separation in the porous region.

**Claims**

**Claims for the following Contracting States : AT; BE, CH, LI, ES, IT NL, PT, SE**

1. A process for producing a semiconductor substrate (13-15) comprising the steps of:

   preparing a first substrate (1, 10, 13) having a porous region (1) and a non-porous semiconductor layer (13) arranged on the porous region;
   bonding the non-porous semiconductor layer to a second substrate (14, 15);
   separating the bonded first and second substrates at the porous region; and
   removing the porous region (11b) remaining on the separated second substrate;

   **characterised in that** the porous region (1) is formed such that the porous region comprises a first porous layer (11) adjacent to the non-porous semiconductor layer (13) and a second porous layer (12) formed under the first porous layer, having a higher porosity and a smaller thickness than those of the first porous layer, and such that the thickness of the second porous layer is not more than 80% of the thickness of the first porous layer and the porosity of the second porous layer is from 30% to 60%.

2. A process according to claim 1, wherein the separation takes place at the second porous layer.

3. A process according to claim 1, wherein the porosity of the first porous layer is less than 30%.

4. A process according to claim 1, wherein the thickness of the second porous layer is not more than 50% of that of the first porous layer.

5. A process according to claim 1, wherein the thickness of the second porous layer is not more than 3 $\mu$m.

6. A process according to claim 1, further comprising forming a porous region anew on a substrate obtained by removing the porous region remaining on the separated first substrate, utilizing the obtained substrate again as the first substrate and bonding the obtained substrate to another new second substrate.

7. A process according to claim 1, further comprising utilizing a substrate obtained by removing the porous region remaining on the separated first substrate again as the second substrate, and bonding the obtained substrate to another new first substrate having a porous region and a non-porous semiconductor layer provided on the porous region.

8. A process according to claim 1, wherein an insulating layer is formed on a surface of the non-porous semiconductor layer of the first substrate and then bonded to the second substrate.

9. A process according to claim 1, wherein an insulating layer is formed on a surface of the second substrate and then bonded to the first substrate.

10. A process according to claim 1, further comprising the step of removing the porous region remaining on the non-porous semiconductor layer of the separated second substrate.

11. A process according to claim 1, wherein the first substrate is a semiconductor wafer with a diameter of 6 inches or less, and wherein the second porous layer has a thickness of 1 nm to 1 µm.

12. A process according to claim 1, wherein the first substrate is a semiconductor wafer with a diameter of 200 mm (8 inches) or more, and wherein the second porous layer has a thickness of 1 µm to 3 µm.

13. A process according to claim 1, wherein anodization is utilized with a change in the anodizing current with the elapse of time to form a plurality of layers different in porosity.

14. A process according to claim 13, wherein the first porous layer has a thickness of at least 3 µm.

15. A process according to claim 1, wherein when forming a plurality of porous layers different in porosity by anodization, the composition of the anodizing liquid is changed to effect anodization, thereby varying the porosity.

16. A process according to claim 15, wherein when changing the composition of the anodizing liquid, at least a component of the anodizing liquid is individually added to the anodizing liquid during the anodization to vary the porosity.

17. A process according to claim 1, wherein when forming a plurality of porous layers different in porosity by anodization, both the anodizing liquid composition and the anodizing current are changed to effect the anodization, thereby varying the porosity.

18. A process according to claim 1, wherein the anodizing current is stopped to flow in the course of anodization; the substrate is taken out from the anodizing liquid; the composition of the anodizing liquid or the setting of the anodizing current is changed; the substrate is again immersed in the anodizing liquid; and the anodizing current is allowed to flow to thereby re-start the anodization.

19. A process according to claim 1, wherein the porous layer, adjacent to the non-porous semiconductor layer and having porosity smaller than of other regions, has an in-plane fluctuation in thickness not more than 35%.

20. A process according to claim 1, wherein the first porous layer has a thickness of 5 µm or more, and wherein the second porous layer has a thickness of 3 µm or less.

21. A method of producing a semiconductor device comprising steps of:

   producing a semiconductor substrate (13-15) having a non-porous semiconductor layer (13) by the process of any of claims 1 to 20; and
   producing semiconductor device elements each defined in and upon said non-porous semiconductor layer.

22. A composite member for a semiconductor substrate, comprising a first substrate (10), a porous region (1) provided on the first substrate, a non-porous semiconductor layer (13) provided on the porous region, and a second substrate (14, 15) provided on the non-porous semiconductor layer; **characterised in that**
   the porous region (1) comprises a first porous layer (11) adjacent to the non-porous semiconductor layer (13) and a second porous layer (12) having a higher porosity and a smaller thickness than those of the first porous layer, and wherein the thickness of the second porous layer is not more than 80% of the thickness of the first porous layer and the porosity of the second porous layer is from 30% to 60%.

23. The composite member according to claim 22, wherein the porosity of the first porous layer is less than 30%.

24. The composite member according to claim 22, wherein the thickness of the second porous layer is not more than 3 µm.

25. The composite member according to claim 22, wherein the first substrate is a semiconductor wafer with a diameter of 150 mm (6 inches) or less, and wherein the second porous layer has a thickness of 1 nm to 1 µm.

26. The composite member according to claim 22, wherein the first substrate is a semiconductor wafer with a diameter of 200 mm (8 inches) or more, and wherein the second porous layer has a thickness of 1 µm to 3 µm.

27. The composite member according to claim 22, wherein the first porous layer has a thickness of 5 µm or more, and wherein the second porous layer has a thickness of 3 µm or less.

**Claims for the following Contracting States : DE, FR, GB**

1. A process for producing a semiconductor substrate (13-15) comprising the steps of:

preparing first substrate (1,10,13) having a porous region (1) and a non-porous semiconductor layer (13) arranged on the porous region;
bonding the non-porous semiconductor layer to a second substrate (14,15);
separating the bonded first and second substrates at the porous region; and
removing the porous region (11b) remaining on the separated second substrate;

wherein the porous region (1) is formed such that the porous region comprises a first porous layer (11) adjacent to the non-porous semiconductor layer (13) and a second porous layer (12), formed under the first porous layer, having a higher porosity, and a smaller thickness than those of the first porous layer, and such that the thickness of the second porous layer is not more than 80% of the thickness of the first porous layer and the porosity of the second porous layer is from 30% to 60%;
wherein
said step of preparing the first substrate (1,10,13) having the porous region (1) is carried out so that the first porous layer (11) has an in-plane fluctuation in thickness of nor more than 35%.

2. A process according to claim 1, wherein the separation takes place at the second porous layer.

3. A process according to claim 1, wherein the porosity of the first porous layer is less than 30%.

4. A process according to claim 1, wherein the thickness of the second porous layer is not more than 50% of that of the first porous layer.

5. A process according to claim 1, wherein the thickness of the second porous layer is not more than 3 $\mu$m.

6. A process according to claim 1, further comprising forming a porous region anew on a substrate obtained by removing the porous region remaining on the separated first substrate, utilizing the obtained substrate again as the first substrate and bonding the obtained substrate to another new second substrate.

7. A process according to claim 1, further comprising utilizing a substrate obtained by removing the porous region remaining on the separated first substrate again as the second substrate, and bonding the obtained substrate to another new first substrate having a porous region and a non-porous semiconductor layer provided on the porous region.

8. A process according to claim 1, wherein an insulating layer is formed on a surface of the non-porous semiconductor layer of the first substrate and then bonded to the second substrate.

9. A process according to claim 1, wherein an insulating layer is formed on a surface of the second substrate and then bonded to the first substrate.

10. A process according to claim 1, further comprising the step of removing the porous region remaining on the non-porous semiconductor layer of the separated second substrate.

11. A process according to claim 1, wherein the first substrate is a semiconductor wafer with a diameter of 150 mm (6 inches) or less, and wherein the second porous layer has a thickness of 1 nm to 1 $\mu$m.

12. A process according to claim 1, wherein the first substrate is a semiconductor wafer with diameter of 200 mm (8 inches) or more, and wherein the second porous layer has a thickness of 1 $\mu$m to 3 $\mu$m.

13. A process according to claim 1, wherein anodization is utilized with a change in the anodizing current with the elapse of time to form a plurality of layers different in porosity.

14. A process according to claim 13, wherein the first porous layer has a thickness of at least 3 $\mu$m.

15. A process according to claim 1, wherein when forming a plurality of porous layers different in porosity by anodization, the composition of the anodizing liquid is changed to effect anodization, thereby varying the porosity.

16. A process according to claim 15, wherein when changing the composition of the anodizing liquid, at least a component of the anodizing liquid is individually added to the anodizing liquid during the anodization to vary the porosity.

17. A process according to claim 1, wherein, when forming a plurality of porous layers different in porosity by anodization, both the anodizing liquid composition and the anodizing current are changed to effect the anodization, thereby varying the porosity.

18. A process according to claim 1, wherein the anodizing current is stopped to flow in the course of anodization; the substrate is taken out from the anodizing liquid; the composition of the anodizing liquid or the setting of the anodizing current is changed; the substrate is again immersed in the anodizing liquid; and the anodizing current is allowed to flow to thereby re-start the anodization.

19. A process according to claim 1, wherein the first porous layer has a thickness of 5 μm or more, and wherein the second porous layer has a thickness of 3 μm or less.

20. A method of producing a semiconductor device comprising steps of:

  producing a semiconductor substrate (13-15) having a non-porous semiconductor layer (13) by the process of any of claims 1 to 19; and
  producing semiconductor device elements each defined in and upon said non-porous semiconductor layer.

21. A composite member for a semiconductor substrate, comprising a first substrate (10), a porous region (1) provided on the first substrate, a non-porous semiconductor layer (13) provided on the porous region, and a second substrate (14,15) provided on the non-porous semiconductor layer;
  wherein the porous region (1) comprises a first porous layer (11) adjacent to the non-porous semiconductor layer (13) and a second porous layer (12), formed under the first porous layer, having a higher porosity and a smaller thickness than those of the first porous layer, and wherein the thickness of the second porous layer is not more than 80% of the thickness of the first porous layer and the porosity of the second porous layer is from 30% to 60%; wherein
  the first porous layer (11) has an in-plane fluctuation in thickness of not more than 35%.

22. A composite member according to claim 21, wherein the porosity of the first porous layer is less than 30%.

23. A composite member according to claim 21, wherein the thickness of the second porous layer is not more than 3 μm.

24. A composite member according to claim 21, wherein the first substrate is a semiconductor wafer with a diameter of 150 mm (6 inches) or less, and wherein the second porous layer has a thickness of 1 nm to 1 μm.

25. A composite member according to claim 21, wherein the first substrate is a semiconductor wafer with a diameter of 200 mm (8 inches) or more, and wherein the second porous layer has a thickness of 1 μm to 3 μm.

26. A composite member according to claim 21, wherein the first porous layer has a thickness of 5 μm or more, and wherein the second porous layer has a thickness of 3 μm or less.


**Patentansprüche**


**Patentansprüche für folgende Vertragsstaaten : AT, BE, CH, LI, ES, IT, NL, PT, SE**

1. Verfahren zur Herstellung eines Halbleitersubstrats (1315), das die folgenden Schritte aufweist:

  Herstellung eines ersten Substrats (1, 10, 13), das einen porösen Bereich (1) und eine nicht poröse Halbleiterschicht (13) aufweist, die auf dem porösen
  Bereich angeordnet ist; Bonden der nicht porösen
  Halbleiterschicht auf ein zweites Substrat (14, 15);

Trennen des gebondeten ersten und zweiten Substrats auf dem porösen Bereich; und
Entfernen des porösen Bereichs (11b), der auf dem getrennten zweiten Substrat verbleibt;

**dadurch gekennzeichnet, dass**

der poröse Bereich (1) derart gebildet wird, dass der poröse Bereich eine erste poröse Schicht (11) nahe zu der nicht porösen Halbleiterschicht (13) und einer zweiten porösen Schicht (12) aufweist, die unter der ersten porösen Schicht gebildet wird, die eine höhere Porosität und eine geringere Dicke aufweist als die der ersten porösen Schicht und derart, dass die Dicke der zweiten porösen Schicht nicht mehr als 80 % der Dicke der ersten porösen Schicht aufweist und die Porosität der zweiten porösen Schicht bei 30 & bis 60 % liegt.

2. Verfahren nach Anspruch 1, wobei die Trennung an der zweiten porösen Schicht eintritt.

3. Verfahren nach Anspruch 1, wobei die Porsität der ersten porösen Schicht weniger als 30 % beträgt.

4. Verfahren nach Anspruch 1, wobei die Dicke der zweiten porösen Schicht nicht mehr als 50 % der ersten porösen Schicht beträgt.

5. Verfahren nach Anspruch 1, wobei die Dicke der zweiten porösen Schicht nicht mehr als 3 $\mu$m beträgt.

6. Verfahren nach Anspruch 1, das weiter die Bildung eines porösen Bereichs von neuem auf einem Substrat aufweist, das durch die Entfernung des porösen Bereichs erhalten wird, der auf dem getrennten ersten Substrat verbleibt, indem das erhaltene Substrat wieder als das erste Substrat verwendet wird und dem Bonden des erhaltenen Substrats auf ein anderes neues zweites Substrat.

7. Verfahren nach Anspruch 1, das weiter die Verwendung eines Substrats aufweist, das durch Entfernen des porösen Bereichs erhalten wird, der auf dem getrennten ersten Substrat wieder als das zweite Substrat verbleibt und dem Bonden des erhaltenen Substrats auf einem anderen neuen ersten Substrat, das einen porösen Bereich und eine nicht poröse Halbleiterschicht aufweist, die auf dem porösen Bereich zur Verfügung gestellt wird.

8. Verfahren nach Anspruch 1, wobei eine isolierende Schicht auf der Oberfläche der nicht porösen Halbleiterschicht des ersten Substrats gebildet wird und dann auf das zweite Substrat gebondet wird.

9. Verfahren nach Anspruch 1, wobei eine isolierende Schicht auf einer Oberfläche des zweiten Substrats gebildet wird und dann auf das erste Substrat gebondet wird.

10. Verfahren nach Anspruch 1, das weiter den Schritt der Entfernung des porösen Bereichs aufweist, der auf der nicht porösen Halbleiterschicht des getrennten zweiten Substrats verbleibt.

11. Verfahren nach Anspruch 1, wobei das erste Substrat ein Halbleiterwafer mit einem Durchmesser von 6 Inches oder weniger ist und wobei die zweite poröse Schicht eine Dicke von 1 nm bis 1 $\mu$m aufweist.

12. Verfahren nach Anspruch 1, wobei das erste Substrat ein Halbleiterwafer mit einem Durchmesser von 200 mm (8 Inches) oder mehr ist und wobei die zweite poröse Schicht eine Dicke von 1 $\mu$m bis 3 $\mu$m aufweist.

13. Verfahren nach Anspruch 1, wobei die Anodisierung mit einer Änderung bei dem Anodisierungsstrom, während dem Verstreichen der Zeit, verwendet wird, um eine Vielzahl an Schichten zu bilden, die verschieden in der Porosität sind.

14. Verfahren nach Anspruch 13, wobei die erste poröse Schicht eine Dicke von zumindest 3 $\mu$m aufweist.

15. Verfahren nach Anspruch 1, wobei, wenn eine Vielzahl von porösen Schichten gebildet wird, die verschieden in der Porosität durch Anodisierung sind, die Zusammensetzung der Anodisierungslösung geändert wird, um die Anodisierung zu bewirken, um dadurch die Porosität zu variieren.

16. Verfahren nach Anspruch 15, wobei, wenn die Zusammensetzung der Anodiserungslösung geändert wird, wird zumindest eine Komponente einzeln zu der Anodisierungslösung, während der Anodisierung, hinzugefügt, um die Porosität zu variieren.

**17.** Verfahren nach Anspruch 1, wobei, wenn eine Vielzahl von porösen Schichten gebildet wird, die verschieden in der Porosität durch Anodisierung sind, werden sowohl die Zusammensetzung der Anodisierungslösung als auch der Anodisierungsstrom geändert, um die Anodisierung zu bewirken, um dadurch die Porosität zu variieren.

**18.** Verfahren nach Anspruch 1, wobei der Anodisierungsstrom gestoppt wird, um in den Anodisierungsverlauf zu fließen; das Substrat wird aus der Anodisierungslösung herausgenommen; die Zusammensetzung der Anodisierungslösung oder die Einstellung des Anodisierungsstroms wird geändert; das Substrat wird wieder in die Anodisierungslösung getaucht; und der Anodisierungsstrom wird fließen gelassen, um dadurch die Anodisierung wieder in Gang zu bringen.

**19.** Verfahren nach Anspruch 1, wobei die poröse Schicht, die benachbart zu der nicht porösen Halbleiterschicht ist und eine niedrigere Porosität als andere Bereiche aufweist,
in der Ebene eine Abweichung der Dicke von nicht mehr als 35% aufweist.

**20.** Verfahren nach Anspruch 1, wobei die erste poröse Schicht eine Dicke von 5 μm oder mehr aufweist und wobei die zweite poröse Schicht eine Dicke von 3 μm oder weniger aufweist.

**21.** Verfahren zur Herstellung einer
Halbleitervorrichtung, das die folgenden Schritte aufweist:

Herstellung eines Halbleitersubstrats (13-15), das eine nicht poröse Halbleiterschicht (13) durch das Verfahren nach irgendeinem der Ansprüche 1 bis 20 aufweist; und
Herstellung von Halbleitervorrichtungs-Elementen, die in und auf der nicht porösen Halbleiterschicht abgegrenzt werden.

**22.** Verbundelement für ein Halbleitersubstrat, das ein erstes Substrat (10), einen porösen Bereich (1) aufweist, der auf dem ersten Substrat zur Verfügung gestellt wird, eine nicht poröse Halbleiterschicht (13), die auf dem porösen Bereich zur Verfügung gestellt wird und ein zweites Substrat (14, 15), das auf der nicht poröse Halbleiterschicht zur Verfügung gestellt wird;
**dadurch gekennzeichnet, dass**
der poröse Bereich (1) eine erste poröse Schicht (11) nahe zu der nicht porösen Halbleiterschicht (13) und einer zweiten porösen Schicht (12) aufweist, die eine höhere Porosität und eine geringere Dicke aufweist, als die der ersten porösen Schicht, und wobei die Dicke der zweiten porösen Schicht nicht mehr als 80 % der Dicke der ersten porösen Schicht aufweist und die Porosität der zweiten porösen Schicht bei 30 % bis 60 % liegt.

**23.** Verbundelement nach Anspruch 22, wobei die Porosität der ersten porösen Schicht weniger als 30 % aufweist.

**24.** Verbundelement nach Anspruch 22, wobei die Dicke der zweiten porösen Schicht nicht mehr als 3 μm beträgt.

**25.** Verbundelement nach Anspruch 22, wobei das erste Substrat ein Halbleiterwafer mit einem Durchmesser von 150 mm (6 Inches) oder weniger ist und wobei die zweite poröse Schicht eine Dicke von 1 nm bis 1 μm aufweist.

**26.** Verbundelement nach Anspruch 22, wobei das erste Substrat ein Halbleiterwafer mit einem Durchmesser von 200 mm (8 Inches) oder mehr ist und wobei die zweite poröse Schicht eine Dicke von 1 μm bis 3 μm aufweist.

**27.** Verbundelement nach Anspruch 22, wobei die erste Schicht eine Dicke von 5 μm oder mehr aufweist und wobei die zweite poröse Schicht eine Dicke von 3 μm oder weniger aufweist.

**Patentansprüche für folgende Vertragsstaaten : DE, FR, GB**

**1.** Verfahren zur Herstellung eines Halbleitersubstrats (13-15), das die folgenden Schritte aufweist:

Herstellung eines ersten Substrats (1, 10, 13), das einen porösen Bereich (1) und eine nicht poröse Halbleiterschicht (13) aufweist, die auf dem porösen Bereich angeordnet ist; Bonden der nicht porösen Halbleiterschicht auf ein zweites Substrat (14, 15);
Trennen des gebondeten ersten und zweiten Substrats auf dem porösen Bereich; und
Entfernen des porösen Bereichs (11b), der auf dem getrennten zweiten Substrat verbleibt;

wobei der poröse Bereich (1) derart gebildet wird, dass der poröse Bereich eine erste poröse Schicht (11) nahe zu der nicht porösen Halbleiterschicht (13) und einer zweiten porösen Schicht (12) aufweist, die unter der ersten porösen Schicht gebildet wird, die eine höhere Porosität und eine geringere Dicke aufweist als die der ersten porösen Schicht und derart, dass die Dicke der zweiten porösen Schicht nicht mehr als 80 % der Dicke der ersten porösen Schicht aufweist und die Porosität der zweiten porösen Schicht bei 30 % bis 60 % liegt; wobei

der Schritt der Herstellung des ersten Substrats (1, 10, 13), das den porösen Bereich (1) aufweist, so ausgeführt wird, dass die erste poröse Schicht (11) in der Ebene eine Abweichung der Dicke von nicht mehr als 35% aufweist.

2. Verfahren nach Anspruch 1, wobei die Trennung an der zweiten porösen Schicht eintritt.

3. Verfahren nach Anspruch 1, wobei die Porsität der ersten porösen Schicht weniger als 30 % beträgt.

4. Verfahren nach Anspruch 1, wobei die Dicke der zweiten porösen Schicht nicht mehr als 50 % der ersten porösen Schicht beträgt.

5. Verfahren nach Anspruch 1, wobei die Dicke der zweiten porösen Schicht nicht mehr als 3 µm beträgt.

6. Verfahren nach Anspruch 1, das weiter die Bildung eines porösen Bereichs von neuem auf einem Substrat aufweist, das durch die Entfernung des porösen Bereichs erhalten wird, der auf dem getrennten ersten Substrat verbleibt, indem das erhaltene Substrat wieder als das erste Substrat verwendet wird und dem Bonden des erhaltenen Substrats auf ein anderes neues zweites Substrat.

7. Verfahren nach Anspruch 1, das weiter die Verwendung eines Substrats aufweist, das durch Entfernen des porösen Bereichs erhalten wird, der auf dem getrennten ersten Substrat wieder als das zweite Substrat verbleibt und dem Bonden des erhaltenen Substrats auf einem anderen neuen ersten Substrat, das einen porösen Bereich und eine nicht poröse Halbleiterschicht aufweist, die auf dem porösen Bereich zur Verfügung gestellt wird.

8. Verfahren nach Anspruch 1, wobei eine isolierende Schicht auf der Oberfläche der nicht porösen Halbleiterschicht des ersten Substrats gebildet wird und dann auf das zweite Substrat gebondet wird.

9. Verfahren nach Anspruch 1, wobei eine isolierende Schicht auf einer Oberfläche des zweiten Substrats gebildet wird und dann auf das erste Substrat gebondet wird.

10. Verfahren nach Anspruch 1, das weiter den Schritt der Entfernung des porösen Bereichs aufweist, der auf der nicht porösen Halbleiterschicht des getrennten zweiten Substrats verbleibt.

11. Verfahren nach Anspruch 1, wobei das erste Substrat ein Halbleiterwafer mit einem Durchmesser von 150 mm (6 Inches) oder weniger ist und wobei die zweite poröse Schicht eine Dicke von 1 nm bis 1 µm aufweist.

12. Verfahren nach Anspruch 1, wobei das erste Substrat ein Halbleiterwafer mit einem Durchmesser von 200 mm (8 Inches) oder mehr ist und wobei die zweite poröse Schicht eine Dicke von 1 µm bis 3 µm aufweist.

13. Verfahren nach Anspruch 1, wobei die Anodisierung mit einer Änderung bei dem Anodisierungsstrom, während dem Verstreichen der Zeit, verwendet wird, um eine Vielzahl an Schichten zu bilden, die verschieden in der Porosität sind.

14. Verfahren nach Anspruch 13, wobei die erste poröse Schicht eine Dicke von zumindest 3 µm aufweist.

15. Verfahren nach Anspruch 1, wobei, wenn eine Vielzahl von porösen Schichten gebildet wird, die verschieden in der Porosität durch Anodisierung sind, die Zusammensetzung der Anodisierungslösung geändert wird, um die Anodisierung zu bewirken, um dadurch die Porosität zu variieren.

16. Verfahren nach Anspruch 15, wobei, wenn die Zusammensetzung der Anodiserungslösung geändert wird, wird zumindest eine Komponente einzeln zu der Anodisierungslösung, während der Anodisierung, hinzugefügt, um die Porosität zu variieren.

17. Verfahren nach Anspruch 1, wobei, wenn eine Vielzahl von porösen Schichten gebildet wird, die verschieden in der Porosität durch Anodisierung sind, werden sowohl die Zusammensetzung der Anodiserungslösung als auch der Anodisierungsstrom geändert, um die Anodisierung zu bewirken, um dadurch die Porosität zu variieren.

18. Verfahren nach Anspruch 1, wobei der Anodisierungsstrom gestoppt wird, um in den Anodisierungsverlauf zu fließen; das Substrat wird aus der Anodisierungslösung herausgenommen; die Zusammensetzung der Anodisierungslösung oder die Einstellung des Anodisierungsstroms wird geändert; das Substrat wird wieder in die Anodisierungslösung getaucht; und der Anodisierungsstrom wird fließen gelassen, um dadurch die Anodisierung wieder in Gang zu bringen.

19. Verfahren nach Anspruch 1, wobei die erste poröse Schicht eine Dicke von 5 μm oder mehr aufweist und wobei die zweite poröse Schicht eine Dicke von 3 μm oder weniger aufweist.

20. Verfahren zur Herstellung einer Halbleitervorrichtung, das die folgenden Schritte aufweist:

    Herstellung eines Halbleitersubstrats (13-15), das eine nicht poröse Halbleiterschicht (13) durch das Verfahren nach irgendeinem der Ansprüche 1 bis 19 aufweist; und
    Herstellung von Halbleitervorrichtungs-Elementen, die in und auf der nicht porösen Halbleiterschicht abgegrenzt werden.

21. Verbundelement für ein Halbleitersubstrat, das ein erstes Substrat (10), einen porösen Bereich (1) aufweist, der auf dem ersten Substrat zur Verfügung gestellt wird, eine nicht poröse Halbleiterschicht (13), die auf dem porösen Bereich zur Verfügung gestellt wird und ein zweites Substrat (14, 15), das auf der nicht poröse Halbleiterschicht zur Verfügung gestellt wird;
    wobei der poröse Bereich (1) eine erste poröse Schicht (11) nahe zu der nicht porösen Halbleiterschicht (13) und einer zweiten porösen Schicht (12) aufweist, die unter der ersten porösen Schicht gebildet wird, die eine höhere Porosität und eine geringere Dicke aufweist, als die der ersten porösen Schicht und wobei die Dicke der zweiten porösen Schicht nicht mehr als 80 % der Dicke der ersten porösen Schicht aufweist und die Porosität der zweiten porösen Schicht bei 30 % bis 60 % liegt;
    wobei
    die erste poröse Schicht (11) in der Ebene eine Abweichung der Dicke von nicht mehr als 35% aufweist.

22. Verbundelement nach Anspruch 21, wobei die Porosität der ersten porösen Schicht weniger als 30 % aufweist.

23. Verbundelement nach Anspruch 21, wobei die Dicke der zweiten porösen Schicht nicht mehr als 3 μm beträgt.

24. Verbundelement nach Anspruch 21, wobei das erste Substrat ein Halbleiterwafer mit einem Durchmesser von 150 mm (6 Inches) oder weniger ist und wobei die zweite poröse Schicht eine Dicke von 1 nm bis 1 μm aufweist.

25. Verbundelement nach Anspruch 21, wobei das erste Substrat ein Halbleiterwafer mit einem Durchmesser von 200 mm (8 Inches) oder mehr ist und wobei die zweite poröse Schicht eine Dicke von 1 μm bis 3 μm aufweist.

26. Verbundelement nach Anspruch 21, wobei die erste Schicht eine Dicke von 5 μm oder mehr aufweist und wobei die zweite poröse Schicht eine Dicke von 3 μm oder weniger aufweist.

**Revendications**

**Revendications pour les Etats contractants suivants : AT, BE, CH, LI, ES, IT, NL, PT, SE**

1. Procédé pour la production d'un substrat semiconducteur (13-15) comprenant les étapes qui consistent :

    à préparer un premier substrat (1, 10, 13) ayant une région poreuse (1) et une couche (13) de semiconducteur non poreux agencée sur la région poreuse ;
    à lier la couche de semiconducteur non poreux à un second substrat (14, 15) ;
    à séparer les premier et second substrats liés au niveau de la région poreuse ; et
    à enlever la région poreuse (11b) restant sur le second substrat séparé ;

**caractérisé en ce que** la région poreuse (1) est formée de manière que la région poreuse comprenne une première couche poreuse (11) adjacente à la couche (13) de semiconducteur non poreux et une seconde couche poreuse (12), formée sous la première couche poreuse, ayant une porosité supérieure et une épaisseur inférieure à celles de la première couche poreuse, et de manière que l'épaisseur de la seconde couche poreuse ne dépasse pas 80 % de l'épaisseur de la première couche poreuse et que la porosité de la seconde couche poreuse aille de 30 % à 60 % ;

2. Procédé selon la revendication 1, dans lequel la séparation a lieu au niveau de la seconde couche poreuse.

3. Procédé selon la revendication 1, dans lequel la porosité de la première couche poreuse est inférieure à 30 %.

4. Procédé selon la revendication 1, dans lequel l'épaisseur de la seconde couche poreuse n'est pas supérieure à 50 % de celle de la première couche poreuse.

5. Procédé selon la revendication 1, dans lequel l'épaisseur de la seconde couche poreuse n'est pas supérieure à 3 μm.

6. Procédé selon la revendication 1, comprenant en outre la formation d'une région poreuse de nouveau sur un substrat obtenu en enlevant la région poreuse restant sur le premier substrat séparé, l'utilisation du substrat obtenu de nouveau en tant que premier substrat et la liaison du substrat obtenu à un nouvel autre second substrat.

7. Procédé selon la revendication 1, comprenant en outre l'utilisation d'un substrat obtenu en enlevant la région poreuse restant sur le premier substrat séparé de nouveau en tant que second substrat, et la liaison du substrat obtenu à un nouvel autre premier substrat ayant une région poreuse et une couche de semiconducteur non poreux située sur la région poreuse.

8. Procédé selon la revendication 1, dans lequel une couche isolante est formée sur une surface de la couche de semiconducteur non poreux du premier substrat puis est liée au second substrat.

9. Procédé selon la revendication 1, dans lequel une couche isolante est formée sur une surface du second substrat, puis est liée au premier substrat.

10. Procédé selon la revendication 1, comprenant en outre l'étape consistant à enlever la région poreuse restant sur la couche de semiconducteur non poreux du second substrat séparé.

11. Procédé selon la revendication 1, dans lequel le premier substrat est une tranche de semiconducteur d'un diamètre de 6 inches ou moins, et dans lequel la seconde couche poreuse a une épaisseur de 1 nm à 1 μm.

12. Procédé selon la revendication 1, dans lequel le premier substrat est une tranche de semiconducteur d'un diamètre de 200 mm (8 inches) ou plus, et dans lequel la seconde couche poreuse a une épaisseur de 1 μm à 3 μm.

13. Procédé selon la revendication 1, dans lequel une anodisation est utilisée avec une variation du courant d'anodisation au fur et à mesure que le temps s'écoule pour former une pluralité de couches ayant des porosités différentes.

14. Procédé selon la revendication 13, dans lequel la première couche poreuse a une épaisseur d'au moins 3 μm.

15. Procédé selon la revendication 1, dans lequel, lors de la formation par anodisation ayant une pluralité de couches poreuses ayant des porosités différentes, on fait varier la composition du liquide d'anodisation pour effectuer l'anodisation, faisant ainsi varier la porosité.

16. Procédé selon la revendication 15, dans lequel, lorsqu'on fait varier la composition du liquide d'anodisation, on ajoute individuellement au moins un constituant du liquide d'anodisation au liquide d'anodisation pendant l'anodisation afin de faire varier la porosité.

17. Procédé selon la revendication 1, dans lequel, lors de la formation par anodisation d'une pluralité de couches poreuses ayant des porosités différentes, on fait varier à la fois la composition du liquide d'anodisation et le courant d'anodisation pour effectuer l'anodisation, faisant ainsi varier la porosité.

**18.** Procédé selon la revendication 1, dans lequel on arrête la circulation du courant d'anodisation au cours de l'anodisation ; on enlève le substrat du liquide d'anodisation ; on modifie la composition du liquide d'anodisation ou le réglage du courant d'anodisation ; on immerge de nouveau le substrat dans le liquide d'anodisation ; et on permet au courant d'anodisation de circuler afin de reprendre l'anodisation.

**19.** Procédé selon la revendication 1, dans lequel la couche poreuse, adjacente à la couche de semiconducteur non poreux et ayant une porosité inférieure à celle d'autres régions, présente une fluctuation d'épaisseur, dans le plan, non supérieure à 35 %.

**20.** Procédé selon la revendication 1, dans lequel la première couche poreuse a une épaisseur de 5 $\mu$m ou plus et dans lequel la seconde couche poreuse a une épaisseur de 3 $\mu$m ou moins.

**21.** Procédé de production d'un dispositif semiconducteur, comprenant les étapes qui consistent :

à produire un substrat semiconducteur (13-15) ayant une couche (13) de semiconducteur non poreux par le procédé selon l'une quelconque des revendications 1 à 20 ; et
à produire des éléments de dispositif semiconducteur définis chacun dans et sur ladite couche de semiconducteur non poreux.

**22.** Elément composite pour un substrat semiconducteur, comportant un premier substrat (10), une région poreuse (1) située sur le premier substrat, une couche (13) de semiconducteur non poreux située sur la région poreuse, et un second substrat (14, 15) situé sur la couche de semiconducteur non poreux ; **caractérisé en ce que**
la région poreuse (1) comprend une première couche poreuse (11) adjacente à la couche (13) de semiconducteur non poreux et une seconde couche poreuse (12), ayant une porosité supérieure et une épaisseur inférieure à celles de la première couche poreuse, et dans lequel l'épaisseur de la seconde couche poreuse n'est pas supérieure à 80 % de l'épaisseur de la première couche poreuse et la porosité de la seconde couche poreuse va de 30 % à 60 % ;

**23.** Elément composite selon la revendication 22, dans lequel la porosité de la première couche poreuse est inférieure à 30 %.

**24.** Elément composite selon la revendication 22, dans lequel l'épaisseur de la seconde couche poreuse n'est pas supérieure à 3 $\mu$m.

**25.** Elément composite selon la revendication 22, dans lequel le premier substrat est une tranche de semiconducteur d'un diamètre de 150 mm (6 inches) ou moins, et dans lequel la seconde couche poreuse a une épaisseur de 1 nm à 1 $\mu$m.

**26.** Elément composite selon la revendication 22, dans lequel le premier substrat est une tranche de semiconducteur d'un diamètre de 200 mm (8 inches) ou plus, et dans lequel la seconde couche poreuse a une épaisseur de 1 $\mu$m à 3 $\mu$m.

**27.** Elément composite selon la revendication 22, dans lequel la première couche poreuse a une épaisseur de 5 $\mu$m ou plus, et dans lequel la seconde couche poreuse a une épaisseur de 3 $\mu$m ou moins.


**Revendications pour les Etats contractants suivants : DE, FR, GB**

**1.** Procédé pour la production d'un substrat semiconducteur (13-15) comprenant les étapes qui consistent :

à préparer un premier substrat (1, 10, 13) ayant une région poreuse (1) et une couche (13) de semiconducteur non poreux agencée sur la région poreuse ;
à lier la couche de semiconducteur non poreux à un second substrat (14, 15) ;
à séparer les premier et second substrats liés au niveau de la région poreuse ; et
à enlever la région poreuse (11b) restant sur le second substrat séparé ;

dans lequel la région poreuse (1) est formée de manière que la région poreuse comprenne une première couche poreuse (11) adjacente à la couche (13) de semiconducteur non poreux et une seconde couche poreuse (12), formée sous la première couche poreuse, ayant une porosité supérieure et une épaisseur inférieure à celles de la première couche poreuse, et de manière que l'épaisseur de la seconde couche poreuse ne dépasse pas 80 % de l'épaisseur de la première couche poreuse et que la porosité de la seconde couche poreuse aille de 30 % à 60 % ;

dans lequel

ladite étape de préparation du premier substrat (1, 10, 13) ayant la région poreuse (1) est exécutée de façon que la première couche poreuse (11) présente une fluctuation d'épaisseur, dans le plan, ne dépassant pas 35 %.

2. Procédé selon la revendication 1, dans lequel la séparation a lieu au niveau de la seconde couche poreuse.

3. Procédé selon la revendication 1, dans lequel la porosité de la première couche poreuse est inférieure à 30 %.

4. Procédé selon la revendication 1, dans lequel l'épaisseur de la seconde couche poreuse n'est pas supérieure à 50 % de celle de la première couche poreuse.

5. Procédé selon la revendication 1, dans lequel l'épaisseur de la seconde couche poreuse n'est pas supérieure à 3 $\mu$m.

6. Procédé selon la revendication 1, comprenant en outre la formation d'une région poreuse de nouveau sur un substrat obtenu en enlevant la région poreuse restant sur le premier substrat séparé, l'utilisation du substrat obtenu de nouveau en tant que premier substrat et la liaison du substrat obtenu à un nouvel autre second substrat.

7. Procédé selon la revendication 1, comprenant en outre l'utilisation d'un substrat obtenu en enlevant la région poreuse restant sur le premier substrat séparé de nouveau en tant que second substrat, et la liaison du substrat obtenu à un nouvel autre premier substrat ayant une région poreuse et une couche de semiconducteur non poreux située sur la région poreuse.

8. Procédé selon la revendication 1, dans lequel une couche isolante est formée sur une surface de la couche de semiconducteur non poreux du premier substrat puis est liée au second substrat.

9. Procédé selon la revendication 1, dans lequel une couche isolante est formée sur une surface du second substrat, puis est liée au premier substrat.

10. Procédé selon la revendication 1, comprenant en outre l'étape consistant à enlever la région poreuse restant sur la couche de semiconducteur non poreux du second substrat séparé.

11. Procédé selon la revendication 1, dans lequel le premier substrat est une tranche de semiconducteur d'un diamètre de 150 mm (6 inches) ou moins, et dans lequel la seconde couche poreuse a une épaisseur de 1 nm à 1 $\mu$m.

12. Procédé selon la revendication 1, dans lequel le premier substrat est une tranche de semiconducteur ayant un diamètre de 200 mm (8 inches) ou plus, et dans lequel la seconde couche poreuse a une épaisseur de 1 $\mu$m à 3 $\mu$m.

13. Procédé selon la revendication 1, dans lequel une anodisation est utilisée avec une variation du courant d'anodisation au fur et à mesure du temps écoulé pour former une pluralité de couches ayant des porosités différentes.

14. Procédé selon la revendication 13, dans lequel la première couche poreuse a une épaisseur d'au moins 3 $\mu$m.

15. Procédé selon la revendication 1, dans lequel, lors de la formation d'une pluralité de couches poreuses par anodisation ayant des porosités différentes, la composition du liquide d'anodisation est modifiée pour effectuer une anodisation, faisant ainsi varier la porosité.

16. Procédé selon la revendication 15, dans lequel, lorsqu'on fait varier la composition du liquide d'anodisation, au moins un constituant du liquide d'anodisation est ajouté individuellement au liquide d'anodisation pendant l'anodisation pour faire varier la porosité.

17. Procédé selon la revendication 1, dans lequel, lors de la formation par anodisation d'une pluralité de couches poreuses, de porosités différentes, on fait varier à la fois la composition du liquide d'anodisation et le courant d'anodisation pour effectuer l'anodisation, faisant ainsi varier la porosité.

**18.** Procédé selon la revendication 1, dans lequel on arrête la circulation du courant d'anodisation au cours de l'anodisation ; on enlève le substrat du liquide d'anodisation ; on modifie la composition du liquide d'anodisation ou le réglage du courant d'anodisation ; on immerge de nouveau le substrat dans le liquide d'anodisation ; et on permet au courant d'anodisation de circuler pour reprendre ainsi l'anodisation.

**19.** Procédé selon la revendication 1, dans lequel la première couche poreuse a une épaisseur de 5 $\mu$m ou plus, et dans lequel la seconde couche poreuse a une épaisseur de 3 $\mu$m ou moins.

**20.** Procédé de production d'un dispositif semiconducteur, comprenant les étapes qui consistent :

à produire un substrat semiconducteur (13-15) ayant une couche (13) de semiconducteur non poreux par le procédé selon l'une quelconque des revendications 1 à 19 ; et
à produire des éléments de dispositif semiconducteur défini chacun dans et sur ladite couche de semiconducteur non poreux.

**21.** Elément composite pour un substrat semiconducteur, comportant un premier substrat (10), une région poreuse (1) située sur le premier substrat, une couche (13) de semiconducteur non poreux située sur la région poreuse, et un second substrat (14, 15) situé sur la couche de semiconducteur non poreux ;
dans lequel la région poreuse (1) comporte une première couche poreuse (11) adjacente à la couche (13) de semiconducteur non poreux et une seconde couche poreuse (12), formée sous la première couche poreuse, et ayant une porosité supérieure et une épaisseur inférieure à celles de la première couche poreuse, et dans lequel l'épaisseur de la seconde couche poreuse n'est pas supérieure à 80 % de l'épaisseur de la première couche poreuse et la porosité de la seconde couche poreuse va de 30 % à 60 % ; dans lequel
la première couche poreuse (11) présente une fluctuation d'épaisseur, dans le plan, ne dépassant pas 35 %.

**22.** Elément composite selon la revendication 21, dans lequel la porosité de la première couche poreuse est inférieure à 30 %.

**23.** Elément composite selon la revendication 21, dans lequel l'épaisseur de la seconde couche poreuse ne dépasse pas 3 $\mu$m.

**24.** Elément composite selon la revendication 21, dans lequel le premier substrat est une tranche de semiconducteur d'un diamètre de 150 mm (6 inches) ou moins, et dans lequel la seconde couche poreuse a une épaisseur de 1 nm à 1 $\mu$m.

**25.** Elément composite selon la revendication 21, dans lequel le premier substrat est une tranche de semiconducteur d'un diamètre de 200 mm (8 inches) ou plus, et dans lequel la seconde couche poreuse a une épaisseur de 1 $\mu$m à 3 $\mu$m.

**26.** Elément composite selon la revendication 21, dans lequel la première couche poreuse a une épaisseur de 5 $\mu$m ou plus, et dans lequel la seconde couche poreuse a une épaisseur de 3 $\mu$m ou moins.

FIG. 1A

FIG. 1B

FIG. 1C

FIG. 1D

FIG. 2A

FIG. 2B

FIG. 2C

FIG. 2D

FIG. 2E

FIG. 3A

FIG. 3B

FIG. 3C

FIG. 3D

FIG. 3E

FIG. 4A

FIG. 4B

FIG. 4C

FIG. 4D

FIG. 4E

# FIG. 5

# FIG. 6

POROSITY 50%

ANODIZING CURRENT FOR SECOND POROUS LAYER

THICKNESS OF FIRST POROUS LAYER ($\mu$m)

# FIG. 7